(19) Europäisches Patentamt
European Patent Office
Office européen des brevets

(11) **EP 2 339 645 A1**

(12) **EUROPEAN PATENT APPLICATION**
published in accordance with Art. 153(4) EPC

(43) Date of publication:
**29.06.2011 Bulletin 2011/26**

(51) Int Cl.:
***H01L 31/042*** *(2006.01)*

(21) Application number: **09817521.9**

(22) Date of filing: **02.10.2009**

(86) International application number:
**PCT/JP2009/005131**

(87) International publication number:
**WO 2010/038482 (08.04.2010 Gazette 2010/14)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **03.10.2008 JP 2008258307**
**19.11.2008 JP 2008295371**

(71) Applicant: **Toppan Printing Co., Ltd.**
**Tokyo 110-8560 (JP)**

(72) Inventors:
• **HOMMA, Hideaki**
  **Tokyo 1108560 (JP)**

• **KAGOTANI, Akihito**
  **Tokyo 110-8560 (JP)**
• **MORONAGA, Kohhei**
  **Tokyo 1108560 (JP)**
• **MURILLO-MORA, Luis Manuel**
  **Tokyo 110-8560 (JP)**

(74) Representative: **Gwilt, Julia Louise**
**Marks & Clerk LLP**
**62-68 Hills Road**
**Cambridge**
**CB2 1LA (GB)**

(54) **SOLAR BATTERY MODULE**

(57)    A solar battery module comprising: a transparent front surface board receiving an incidence of a light; a packed bed which allows a light, which passed through the front surface board, to pass through; a solar battery cell comprising a light receiving surface and is fixed by the packed bed, wherein a light which passed through the packed bed is received by the receiving light surface and is converted into electricity; and a light reusing sheet positioned at a back surface side of the light receiving surface of the solar battery cell, the light reusing sheet comprising a reflecting layer comprising a reflecting surface which reflects a light which was not received by the light receiving surface.

FIG. 1

EP 2 339 645 A1

**Description**

TECHNICAL FIELD

The present invention relates to a light reusing sheet which includes a reflecting surface at one surface which reflects light, allowing reuse of light by reflecting light in a particular direction. The present invention also relates to a solar battery module which uses the light reusing sheet.

The present application claims priority on Japanese Patent Application No. 2008-258307, filed October 3, 2008, as well as on Japanese Patent Application No. 2008-295371, filed November 19, 2008, the contents of which are incorporated by reference.

BACKGROUND ART

In recent years, the use of solar battery modules has become more and more widespread. The use of solar battery modules is promoted in various fields. For example, a relatively small solar battery module is equipped in small electronic devices such as calculators. Another example is a solar battery module equipped on houses for household use. A solar battery power generating system with a large area is also used in large scale power generating facilities. A further example of the use of a solar battery module may be seen in the electrical power of an artificial satellite. (See, for instance, Patent Document 1.)

According to such solar batteries, the production of electricity increases primarily in proportion to the area at which light is irradiated. Therefore, in order to enhance the efficiency of electrical production, it is important to improve manufacturing technology such as encapsulating technology and film-forming technology. At the same time, it is important to increase the aperture ratio (the ratio of an area at which electrical production is possible as opposed to the total area) of a solar battery module.

Furthermore, considering single crystal silicon and poly crystal silicon in particular, there is a problem in that the cost of silicon is high. Moreover, there is an additional cost of pasting on silicon.

Therefore, a solar power cell with thin film silicon is used so that there is a small amount of silicon, which is a component of the solar power cell, and so that a film may be formed by technology such as CVD.

However, the light absorbing ratio of the above-mentioned solar power cell with thin film silicon, in particular, is small because infrared light can more easily permeate the solar power cell with thin film silicon. Therefore, in order to increase the light usage efficiency, the incident light is scattered. Thus, the light usage efficiency is increased by increasing the distance through which light passes through the solar power cell with thin film silicon.

In general, there are two types of amorphous silicon solar battery in terms of configuration. The first type is a configuration in which a transparent conducting film such as $SnO_2$, ITO, and the like is formed on a translucent substrate such as glass, and further on top, a p-layer, an i-layer, and an n-layer of an amorphous silicon (Si) are stacked up in this order. The second type is a configuration in which an n-layer, an i-layer, and a p-layer of an amorphous silicon (Si) are stacked up in this order on top of a metal substrate electrode, thus forming a photoelectric conversion active layer, and further on top, a transparent conducting film is stacked.

In particular, the first type of configuration is currently used frequently because, when the amorphous semiconductor is formed in the order of a p-layer, an i-layer, and an n-layer, the translucent insulating substrate may also be used as the surface cover glass of the solar battery. Another reason is because a plasma-resistant transparent conducting film such as $SnO_2$ is developed, and it has become possible to form an amorphous semiconductor photoelectric conversion active layer using a plasma CVD method.

Incidentally, in order to form the amorphous semiconductor photoelectric conversion active layer, it is possible to use a plasma CVD method by a glow electric discharge decomposition of raw material gas, as well as a vapor-phase epitaxial method by a light CVD method. According to these methods, there is an advantage such that a thin film with a large area may be formed.

An amorphous Si solar battery may be formed at a relatively low temperature at approximately 100°C to 200°C. Therefore, as a substrate to form the amorphous Si solar battery, it is possible to use substrates made of a variety of materials. However, a glass substrate and a stainless steel substrate are most often used.

Incidentally, an amorphous Si solar battery is such that the thickness of a light absorbing layer of a silicon at the time when the efficiency of converting light to electricity is the maximum equals approximately 500 nm. Therefore, in order to increase the conversion efficiency, it is crucial to increase the amount of light absorbed within the thickness of the light absorption layer. Accordingly, the light path of light within the light absorbing layer has been conventionally elongated by, for instance, forming a transparent conducting film with concaved and convex portions on its surface on top of a glass substrate, or by forming a metallic layer with concaved and convex portions on its surface on top of a stainless steel substrate.

When the length of the light path within the light absorbing layer of the solar battery is increased by these methods, the usage efficiency of light increases prominently compared to an instance in which an amorphous silicon solar battery is formed on a flat substrate on which there are no minute concaved and convex portions on the surface.

Incidentally, a general method for forming minute concaved and convex portions on the surface of a glass substrate is a method in which an $SnO_2$ film, a transparent electrode, is formed by a constant pressure CVD method. Further, as a method to form minute concaved and convex portions on a metal substrate such as a stainless steel, a method is used in which an adjustment is made to the conditions for forming the Ag with the vapor deposition method and the sputtering method, or a method in which a heat processing is performed after the Ag is formed.

This thin film solar battery is configured by forming in series on top of a translucent insulating substrate, a transparent conducting film, a hydrogenated amorphous silicon carbide (a-SiC:H) p layer, a hydrogenated amorphous silicon (a-Si:H) i layer, a hydrogenated amorphous silicon (a-Si:H) n layer, a transparent conducting film, and a back side electrode. Further, as described above, concaved and convex portions are formed on the surface of the transparent conducting film. As a result, each layer formed in an upper portion comprises a concaved and convex structure.

Moreover, when a semiconductor element such as a thin film solar battery and the like is formed on top of a flexible substrate or a light weight substrate, a polyimid resin with a high heat resistance has been used. A method for creating concaved and convex portions on such a resin is disclosed in Patent Document 2 and the like.

In addition, Patent Document 3 gives a disclosure of a patent such that the a usage efficiency of light is enhanced by a periodic structure of a V channel, thereby creating a retroreflection of light. Patent Document 3 includes a statement that the peak angle of the V channel is preferably between 50 degrees to 90 degrees. Further, Patent Document 3 includes a statement that the pitch of the period of the V channel is preferably between 10 $\mu$m to 20 $\mu$m.

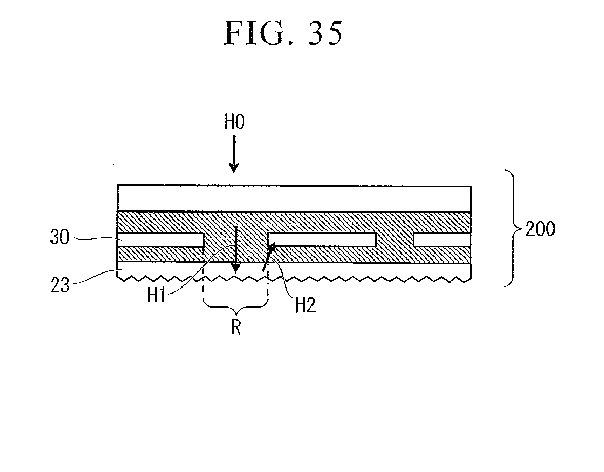

FIG. 35 is a cross sectional view showing a solar battery module 200 using a conventional back side material 23. Since a leak electric current occurs when the distance between the positions of the solar battery cell 30 is narrowed, a region R between adjacent solar battery cells 30 becomes necessary. As indicated in FIG. 35, among the incident light H0 entering the solar battery module 200, the incident light H1 entering the region R is reflected by placing the back side material 23 to the back side of the solar battery module 200, and is reused as a reflected light H2 (Patent Document 4). However, a sufficient power generating efficiency has not yet been achieved.

[Prior Art Document]

[Patent Document]

[Patent Document 1] Japanese Unexamined Patent Application, First Publication No. 2001-295437
[Patent Document 2] Japanese Unexamined Patent Application, First Publication No. H4-61285
[Patent Document 3] Japanese Unexamined Patent Application, First Publication No. H11-274533
[Patent Document 4] Japanese Unexamined Patent Application, First Publication No. H11-307791

DISCLOSURE OF INVENTION

[Problems to be Solved by the Invention]

As described above, although there is a demand to increase the power generating efficiency per unit of area of the conventional solar battery module, the increase has not been adequate.

The present invention is made in light of these objects. Therefore, an object of the present invention is to provide a light sheet comprising concaved and convex portions which are the most suitable for enhancing the light usage efficiency. Another object of the present invention is to provide a solar battery module using them.

[Means for Solving the Problems]

In order to achieve the above object, the present invention provides a light reusing sheet for a solar battery module as well as a solar battery module, as described below.

In other words, a light reusing sheet for a solar battery module according to an aspect of the present invention includes a reflecting layer including a reflecting surface which reflects light, wherein a Gaussian curvature of the reflecting surface equals zero.

The light reusing sheet for the solar battery module may be configured as follows: among the reflecting surface, a percentage of an area of the reflecting surface at which a Gaussian curvature equals zero is greater than or equal to 90 percent of a total area of the reflecting surface.

The light reusing sheet for the solar battery module may be configured as follows: the reflecting surface comprises a concaved and convex form, and the concaved and convex form has a periodicity.

The light reusing sheet for the solar battery module may be configured as follows: a pitch of the periodicity of the concaved and convex form is greater than or equal to 25 $\mu$m and is less than or equal to 300 $\mu$m.

The light reusing sheet for the solar battery module may be configured as follows: a pitch of the periodicity of the concaved and convex form is greater than or equal to 50 $\mu$m and is less than or equal to 200 $\mu$m.

In addition, a solar battery module according to an aspect of the present invention includes a transparent front surface board receiving an incidence of a light; a packed bed which allows a light, which passed through the front surface board, to pass through; a solar battery cell including a light receiving surface and is fixed by the packed bed, wherein a light which passed through the packed bed is received by the receiving light surface and is converted into electricity; and a light reusing sheet positioned at a back surface side of the light receiving surface of the solar battery cell, the light reusing sheet including a reflecting layer including a reflecting surface which reflects a light which was not received by the light receiving surface, wherein a Gaussian curvature of the reflecting surface equals zero.

In addition, a solar battery module according to an aspect of the present invention includes a transparent front surface board receiving an incidence of a light; a packed bed which allows a light, which passed through the front surface board, to pass through; a solar battery cell including a light receiving surface and is fixed by the packed bed, wherein a light which passed through the packed bed is received by the receiving light surface and is converted into electricity; a light reusing sheet positioned at a back surface side of the light receiving surface of the solar battery cell, the light reusing sheet including a reflecting layer including a reflecting surface which reflects a light which was not received by the light receiving surface, wherein among the reflecting surface, a percentage of an area of the reflecting surface such that a Gaussian curvature equals zero is greater than or equal to 90 percent of a total area of the reflecting surface.

The solar battery module may be configured as follows: a refraction index n of a material, at a front surface board side of the reflecting surface, and an angle $\theta$ (deg) between a normal line of the front surface board and a normal line of the reflecting surface satisfy a first equation $\theta \geq \arcsin(1/n)/2$, and an apex angle $\alpha$ (deg) of the reflecting surface satisfies a second equation $\alpha \geq (\arcsin(1/n)+180)/2$.

The solar battery module may be configured as follows: a percentage of an area of the reflecting surface satisfying the following condition is greater than or equal to 50 percent of a total area of the reflecting surface: a refraction index n of a material, at a front surface board side of the reflecting surface, and an angle $\theta$ (deg) between a normal line of the front surface board and a normal line of the reflecting surface satisfy a first equation $\theta \geq \arcsin(1/n)/2$, and an apex angle $\alpha$ (deg) of the reflecting surface satisfies a second equation $\alpha \geq (\arcsin(1/n)+180)/2$.

The solar battery module may be configured as follows: the reflecting surface comprises a concaved and convex form, and the concaved and convex form has a periodicity.

The solar battery module may be configured as follows: a pitch of the periodicity of the concaved and convex form is greater than or equal to 25 $\mu$m and is less than or equal to 300 $\mu$m.

The solar battery module may be configured as follows: a pitch of the periodicity of the concaved and convex form is greater than or equal to 50 $\mu$m and is less than or equal to 200 $\mu$m.

EFFECTS OF THE INVENTION

According to a method based on the present invention, it is possible to enhance the usage efficiency of light by reusing an incident light. It is also possible to provide a solar battery module with a good power generating efficiency.

BRIEF DESCRIPTION OF THE DRAWINGS

FIG. 1 is a cross sectional view showing an example of a solar battery module according to the present invention.
FIG. 2 is a perspective view showing an example of a reflecting surface of a light reusing sheet according to the present invention.
FIG. 3 is a perspective view showing an example of a reflecting surface of a light reusing sheet according to the present invention.
FIG. 4 is a perspective view showing an example of a reflecting surface of a light reusing sheet according to the present invention.
FIG. 5 is a perspective view showing an example of a reflecting surface of a light reusing sheet according to the present invention.
FIG. 6 is a perspective view showing an example of a reflecting surface of a light reusing sheet according to the present invention.
FIG. 7 is a perspective view showing an example of a reflecting surface of a light reusing sheet according to the present invention.

FIG. 8A is a diagram showing an example of a light distribution of a reflecting surface.

FIG. 8B is a diagram showing an example of a light distribution of a reflecting surface.

FIG. 8C is a diagram showing an example of a light distribution of a reflecting surface.

FIG. 8D is a diagram showing an example of a light distribution of a reflecting surface.

FIG. 8E is a diagram showing an example of a light distribution of a reflecting surface.

FIG. 9 is a frontal view showing an example of a solar battery module according to the present invention.

FIG. 10 is a frontal view showing an example of a solar battery module according to the present invention.

FIG. 11 is a diagram showing a change of a reflection rate with respect to an incident angle.

FIG. 12 is a cross sectional diagram showing an example of a reflecting surface of a light reusing sheet according to the present invention.

FIG. 13 is a diagram showing an angular range of a reflecting surface of a light reusing sheet.

FIG. 14 is a cross sectional diagram showing an example of a reflecting surface of a light reusing sheet according to the present invention.

FIG. 15 is a cross sectional diagram showing an example of a reflecting surface of a light reusing sheet according to the present invention.

FIG. 16 is a cross sectional diagram showing an example of a reflecting surface of a light reusing sheet according to the present invention.

FIG. 17 is a cross sectional diagram showing an example of a reflecting surface of a light reusing sheet according to the present invention.

FIG. 18 is a cross sectional diagram showing an example of a reflecting surface of a light reusing sheet according to the present invention.

FIG. 19 is a cross sectional diagram showing an example of a reflecting surface of a light reusing sheet according to the present invention.

FIG. 20 is a cross sectional diagram showing an example of a reflecting surface of a light reusing sheet according to the present invention.

FIG. 21 is a cross sectional diagram showing an example of a reflecting surface of a light reusing sheet according to the present invention.

FIG. 22 is a cross sectional diagram showing an example of a reflecting surface of a light reusing sheet according to the present invention.

FIG. 23 is a cross sectional diagram showing an example of a reflecting surface of a light reusing sheet according to the present invention.

FIG. 24 is a cross sectional diagram showing an example of a reflecting surface of a light reusing sheet according to the present invention.

FIG. 25 is a cross sectional diagram showing an example of a reflecting surface of a light reusing sheet according to the present invention.

FIG. 26 is a cross sectional diagram showing an example of a reflecting surface of a light reusing sheet according to the present invention.

FIG. 27 is a cross sectional diagram showing an example of a reflecting surface of a light reusing sheet according to the present invention.

FIG. 28 is a cross sectional diagram showing an example of a light reusing sheet according to the present invention.

FIG. 29 is a cross sectional diagram showing an example of a light reusing sheet according to the present invention.

FIG. 30 is a cross sectional diagram showing an example of a light reusing sheet according to the present invention.

FIG. 31 is a cross sectional diagram showing an example of a light reusing sheet according to the present invention.

FIG. 32 is a cross sectional diagram showing an example of a solar battery module according to the present invention.

FIG. 33 is a cross sectional diagram showing an example of a solar battery module according to the present invention.

FIG. 34 is a cross sectional diagram showing an example of a solar battery module according to the present invention.

FIG. 35 is a cross sectional diagram showing a solar battery module using a conventional back side material.

EMBODIMENTS FOR CARRYING OUT THE INVENTION

First, a solar battery module 200 according to the present invention is described.

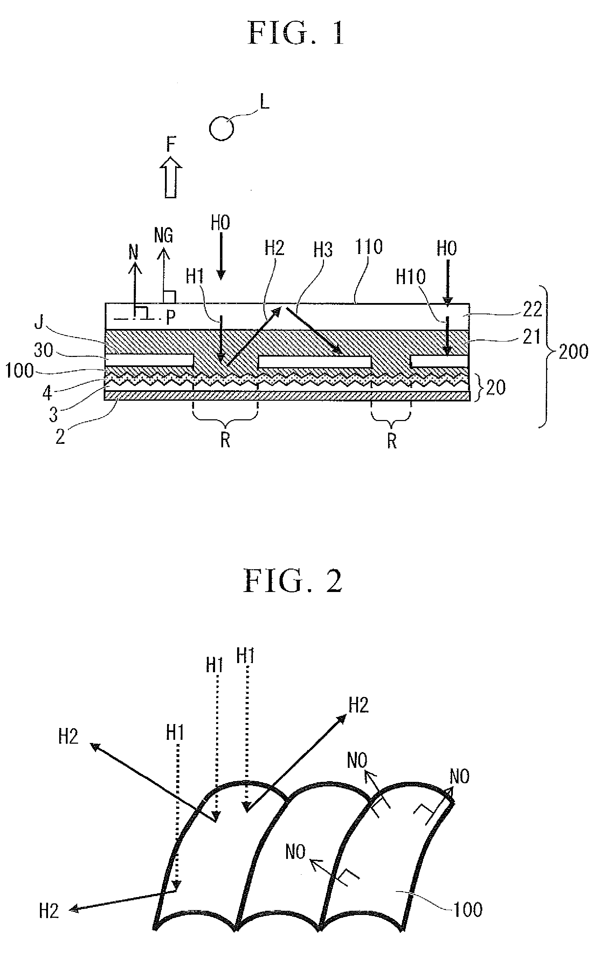

FIG. 1 shows a cross sectional diagram showing an embodiment of the solar battery module 200 based on the present invention. The solar battery module 200 according to the present invention comprises a front surface board 22, a packed bed 21, and a light reusing sheet 20.

The front surface board 22 allows light, such as a solar light or an illuminating light to pass through from a light source L. The front surface board 22 protects the solar battery cell 30 from impact, dirt, and entry of moisture and the like. The front surface board 22 comprises a transparent material with a high passage rate.

The incident light H0 is a light coming out of the light source L and entering the incident surface 110 orthogonally from a side F of the solar light and illuminating light. After the incident light H0 enters the front surface board 22, the incident light H0 passes through the front surface board 22, and comes out to the packed bed 21.

Incidentally, the normal line NG of the incident surface 110 is parallel to the direction of the normal line N of the flat surface P. Here, when the front surface board 22 is on the flat surface P, the front surface board 22 is in the most stable condition.

The incident light H0 entering the incident surface 110 orthogonally enters the solar battery module 200 parallel to the normal line NG.

The material of the front surface board 22 is glass such as reinforced glass and sapphire glass, or a resin sheet such as PC (polycarbonate), PEN (polyethylene naphthalate), and the like. Regarding the thickness of the front surface board 22, a thickness of approximately 3mm to 6mm is used for reinforced glass, and a thickness of approximately $100\mu m$ to $3000\mu m$ is used for a resin sheet.

The light being ejected from the front surface board 22 enters the packed bed 21. The packed bed 21 seals the solar battery cell 30. The incident light H0 which entered the front surface board 22 passes through the packed bed 21, and becomes an incident light H10 into the solar battery cell 30, while a part of the light becomes an incident light H1 which is ejected to the light reusing sheet 20. In order to allow the incident light H0, which entered the packed bed 21, to pass through, a material with a high light beam passage rate is used for the packed bed such as a nonflammable EVA (ethylene, vinyl, acetate).

Furthermore, the solar battery cell 30 is configured so that a conversion is made from a light entering the light receiving surface J to electricity according to a photoelectric effect. There are various types such as a single crystal silicon type, a multicrystal silicon type, a thin film silicon type, and a CISG (a compound of Cu, In, Ga, and Se) series thin film type. The solar battery cell 30 is used by connecting a plurality of solar battery cells 30 with an electrode, thereby forming a module. The incident light H10 from the packed bed 21 to the solar battery cell 30 is converted to electricity at the solar battery cell 30.

Usually, a light which has entered the incident surface 110 diagonally with respect to the incident surface 110 is reflected by a large proportion, while the amount of light entering the solar battery cell 30 is small. Therefore, the amount of light which can be used for power generation is small.

Therefore, when the incident light H0 enters the incident surface 110 orthogonally, the efficiency is maximized.

The light reusing sheet 20 is configured so that light which has passed through the solar battery cell 30 itself or the incident light H1 which entered between the solar battery cell 30 is reflected at the reflecting surface 100. The reflected light H2 is reflected again at a boundary between, for example, the front surface board 22 and the atmosphere, and becomes an incident light H3 which enters the light receiving surface J of the solar battery cell 30, and undergoes a photoelectric conversion. As a result, there is an effect such that, compared with a configuration in which there is no light reusing sheet 20, the light reusing effect increases.

The direction in which the reflected light H2 proceeds may be controlled by the concaved and convex structure of the reflecting surface 100 according to the present invention. Thus, a large amount of light may be entered into the light receiving surface J. The concaved and convex structure of the reflecting surface 100 is described using its normal line N0 and the Gaussian curvature Kg.

Incidentally, the normal line N0 of the reflecting surface 100 is a line perpendicular to a tangential surface at an arbitrary point on the reflecting surface 100. The sheet normal line NB is parallel to the normal line N of the flat surface P when the light reusing sheet 20 is placed on the flat surface P in a stable condition. The angle θ representing a direction of the reflecting surface 100 becomes an angle between the normal line N0 of the reflecting surface 100 and the sheet normal line NB.

Usually, the sheet normal line NB is placed so as to be parallel to the normal line N0 of the incident surface 100. Therefore, the incident light H1 makes an entrance parallel to the sheet normal line NB.

Next, the Gaussian curvature Kg represents a curvature of a curved surface, and is generally represented as follows. In other words, among the curvature K of the curve of a cross section passing through a particular point on a curved surface, setting the minimum curvature to K1 and the maximum curvature to K2 allows the Gaussian curvature Kg of the curved surface to be defined by the product of the maximum value K2 and the minimum value K1 of the curvature K of the curved line according to the Equation 1 shown below.

$$Kg = K1 \times K2 \qquad (Equation\ 1)$$

Next, cases are considered in which the Gaussian curvature Kg of the reflecting surface 100 is a positive value, negative value, and zero.

It is known that, when a quadratic surface in three dimension has a positive Gaussian curvature Kg, the quadratic surface is spherical. Meanwhile, when the quadratic surface has a negative curvature, the quadratic surface is shaped as a horseshoe. When the Gaussian curvature Kg equals zero, it is known that the quadratic surface becomes, for example, tubular or a surface forming a part of a cone.

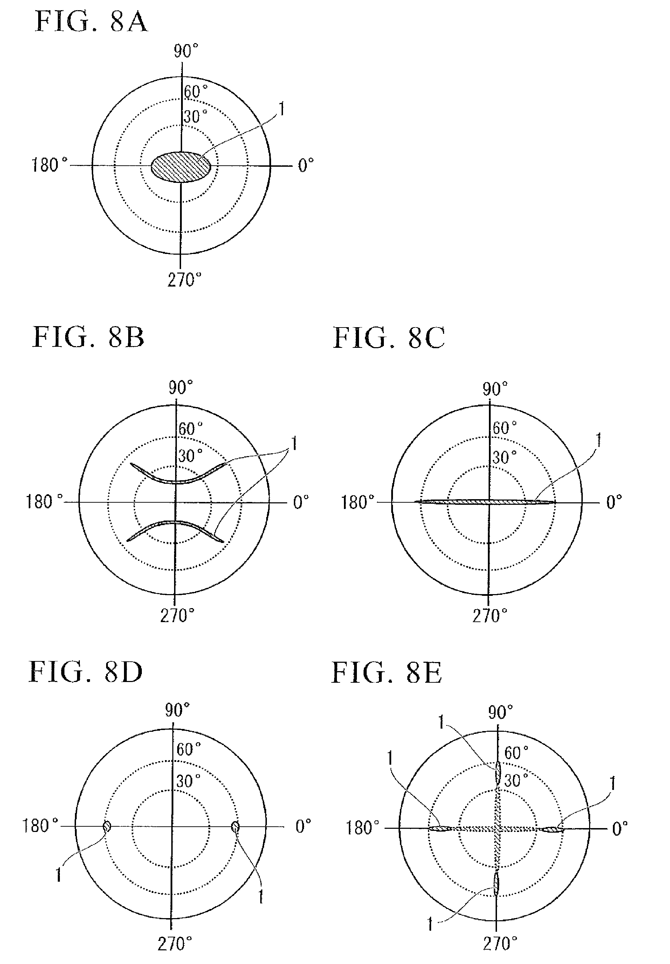

FIG. 2 is a perspective view showing an example of a reflecting surface of a light reusing sheet according to the present invention when the Gaussian curvature Kg is positive. As shown in FIG. 2, when an incident light H1 parallel to the sheet normal line NB enters the reflecting surface 100 having a positive Gaussian curvature Kg, the reflecting light H2 is dispersed in parabolic form at the reflecting surface 100. The light distribution 1 of the reflecting light H2 at this time is shown in FIG. 8A.

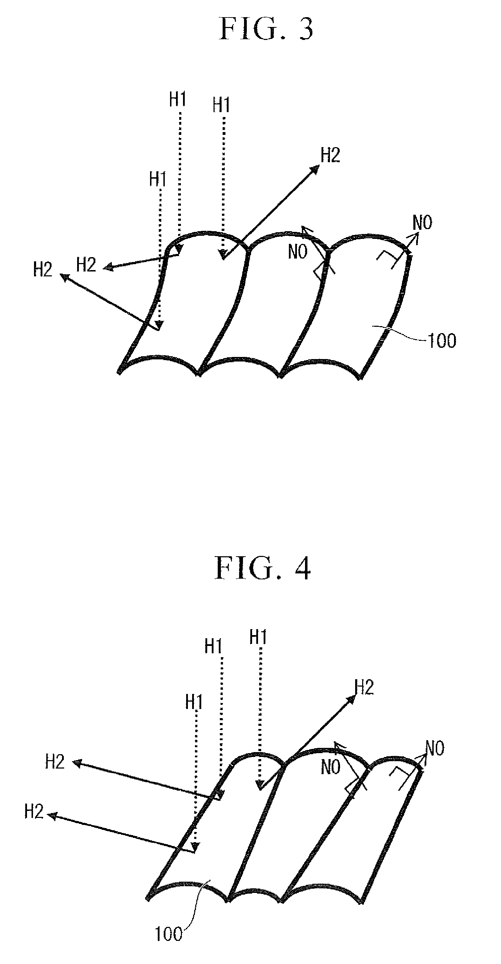

FIG. 3 is a perspective view showing an example of a reflecting surface of a light reusing sheet according to the present invention when the Gaussian curvature Kg is negative. When the Gaussian curvature Kg is negative, as shown in FIG. 3, the incident light H1 similarly enters the reflecting surface 100 in a manner parallel to the sheet normal line NB, and the reflecting light H2 is dispersed in a parabolic form. The light distribution 1 of the reflecting light H2 similarly becomes what is shown in FIG. 8A.

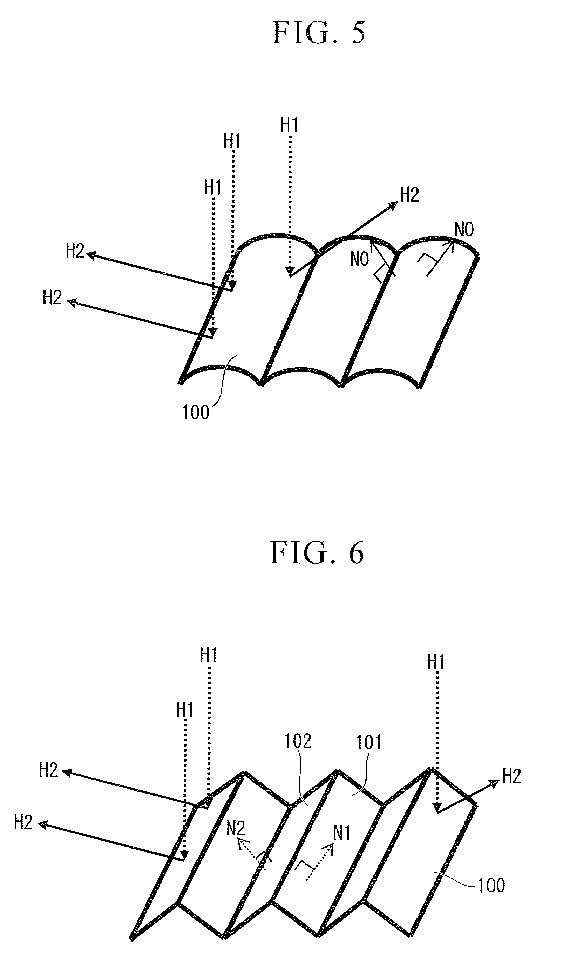

On the other hand, two cases are described when the Gaussian curvature Kg equals zero. FIGS. 4 and 5 are perspective views representing an example of a reflecting surface of a light reusing sheet according to the present invention when the Gaussian curvature Kg equals zero. One is an instance in which the reflecting surface 100 is shaped as if a part of a cone has been cut. This is shown in FIG. 4.
Here, the light distribution 1 of the reflecting light H2 which is obtained by the incident light H1 parallel to the sheet normal line NB reflecting at the reflecting surface 100 is not parabolic, but takes a curved form as shown in FIG. 8B.

Meanwhile, when the normal line N0 of the reflecting surface 100, as shown in FIG. 5, is a shape obtained by cutting out a portion of a cylinder, the light distribution 1 of the reflecting light H2 which is obtained by the incident light H1 parallel to the sheet normal line NB reflecting at the reflecting surface 100, becomes as shown in FIG. 8C.
FIG. 6 is a perspective view showing an example of a reflecting surface of the light reusing sheet according to the present invention. As shown in FIG. 6, when the reflecting surface 100 includes a plurality of reflecting surfaces 101 and 102, the Gaussian curvature Kg inside the surface of each of the reflecting surfaces 101, 102 naturally becomes equal to 0. At this time, the light distribution 1 of the reflecting light H2 which is obtained by the incident light H1 parallel to the sheet normal line NB reflecting at the reflecting surface 100, becomes as shown in FIG. 8D.

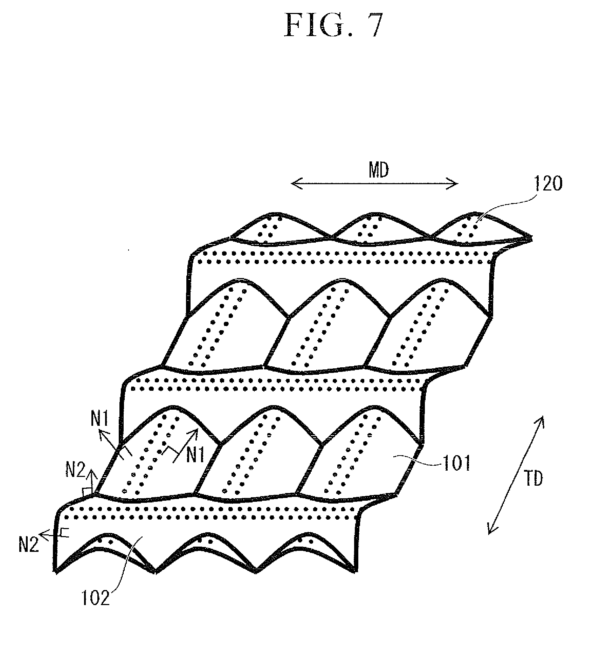

FIG. 7 is a perspective view showing an example of a reflecting surface of the light reusing sheet according to the present invention. FIG. 7 shows an instance in which the reflecting surface 100 includes a plurality of reflecting surfaces 101, 102, and each of the reflecting surfaces 101, 102 has a ridge line 120. In the case indicated in FIG. 7, the Gaussian curvature Kg is also zero inside the reflecting surfaces 101, 102. At this time, the light distribution 1 of the reflecting light H2 which is obtained by the incident light H1 parallel to the sheet normal line NB reflecting at the reflecting surfaces 101, 102, is shown in FIG. 8E.
In other words, as shown in FIGS. 4 to 7, when the Gaussian curvature Kg of the reflecting surface 100 becomes zero, the reflecting light H2 is neither dispersed nor concentrated, but displays a light distribution in the form of a curved line or a straight line, as indicated in FIGS. 8B to 8E.

Incidentally, at region R between adjacent solar battery cells 30, a photoelectric conversion is not conducted. However, the incident light H1 illuminated to this region R enters the light reusing sheet 20. As a result, the incident light H1 may be used effectively by making the reflecting light H2 face the side of the light receiving surface J at the side of the solar battery cell 30. At this time, as are the cases indicated in FIGS. 4 to 7, when the Gaussian curvature Kg of the reflecting surface 100 is zero, the reflecting light H2 is reflected in a particular direction without being dispersed or concentrated. As a result, the reflecting light H2 may be ejected in the direction of the solar battery cell 30 in an efficient manner.

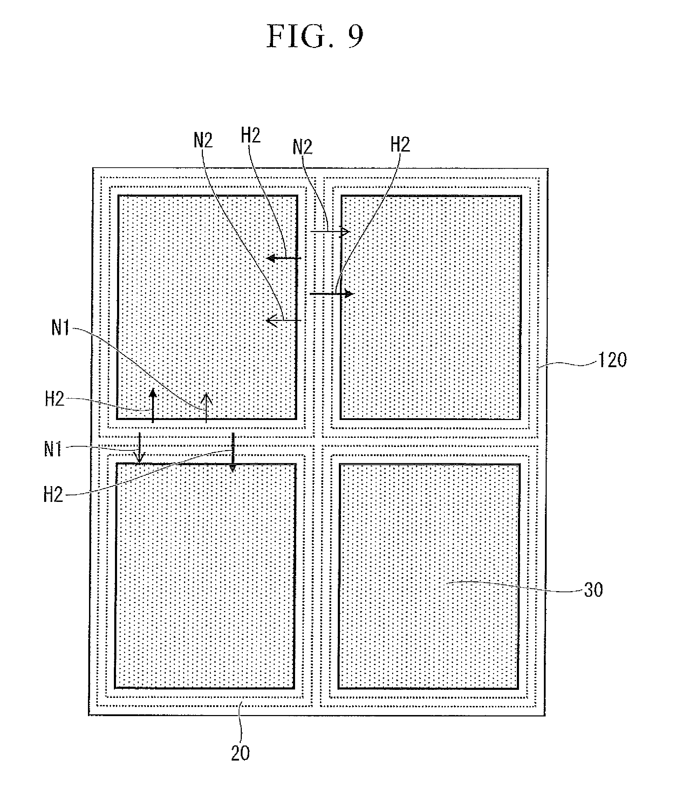

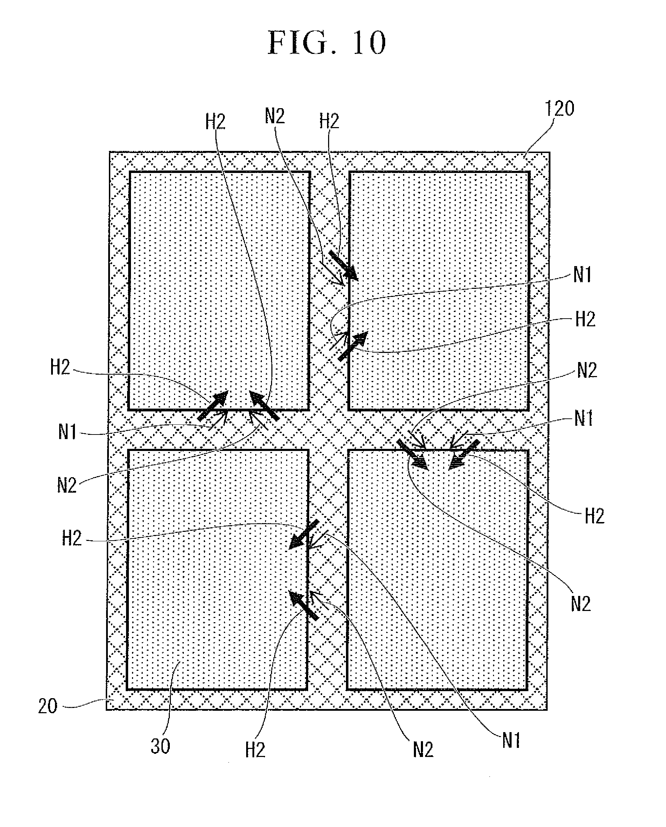

Furthermore, it is preferable that the normal lines N1 and N2 of the reflecting surface 100 be facing in the direction of the solar battery cell 30 so that the reflecting light H2 reflecting at the reflecting surface 100 faces in the direction of the solar battery cell 30. FIGS. 9 and 10 are diagrams showing an example of such a solar battery module. In this way, it is possible to reuse the reflecting light H2 more effectively.

Incidentally, it is preferable that the ratio of the surface of the reflecting surface 100 with a Gaussian curvature Kg of zero be greater than or equal to 90 percent and less than or equal to 100 percent of the reflecting surface 100. If the ratio of the surface with a Gaussian curvature Kg of zero is less than 90 percent, the reflecting light H2 cannot be ejected in the direction of the solar battery cell 30 in an adequately efficient manner.

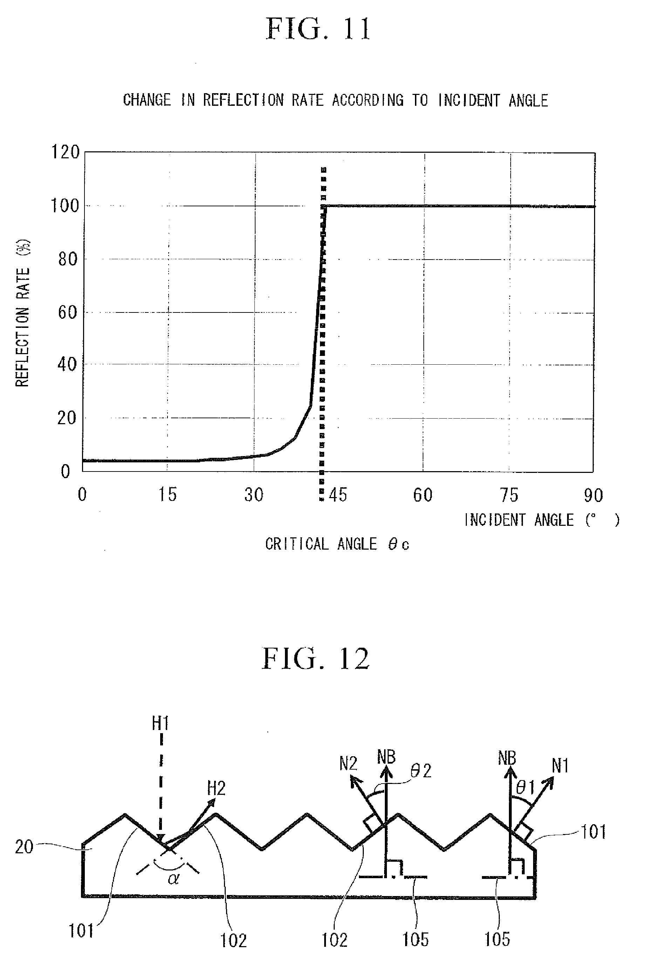

Further, if the angle between the incident light H1 and the reflecting light H2 is increased, the reflecting light H2 may be entered into the light receiving surface J of the separated solar battery cell 30. As a result, it is possible to use the incident light H1 which entered at a place distanced from the solar battery cell 30. Thus, the reflecting light H2 entering the light receiving surface J increases. As a result, it is possible to increase the usage efficiency of the light.
In order to accomplish the above, the angle θ1 of the reflecting surface 100 may be increased. If the angle of the reflecting light H2 is greater than or equal to 45 degrees, a sufficient effect may be obtained. In other words, it is preferable that the angle θ1 of the reflecting surface 100 be greater than or equal to 45/2 degrees = 22.5 degrees. If the angle θ1 of the reflecting surface 100 is less than 22.5 degrees, the incident light H1 entering the region R orthogonally between adjacent solar battery cells 30 of the solar battery module 200 cannot sufficiently reflect in the direction of the solar battery cell 30. Therefore, the reflecting light H2 entering the light receiving surface J cannot be sufficiently obtained. However, when the angle θ1 is greater than 30 degrees, the reflecting light H2 undergoes multiple reflections. FIG. 12 is a diagram showing an example of the reflecting surface 100 when multiple reflections have occurred. If the angle θ1 of the reflecting surface 100 is less than or equal to 30 degrees, multiple reflections do not occur. As a result, it is preferable that as the angle θ1 of the reflecting surface 100 be less than or equal to 30 degrees.

Further, it is preferable that the ratio of the area among the reflecting surface 100, such that the angle θ1 of the reflecting surface 100 is greater than or equal to 22.5 degrees and is less than or equal to 30 degrees, is greater than or equal to the ratio of the area such that the angle θ1 of the reflecting surface 100 is less than 22.5 degrees and is greater than 30 degrees. Among the reflecting surface 100, if the ratio of the area, such that the angle θ1 of the reflecting surface 100 is greater than or equal to 22.5 degrees and is less than or equal to 30 degrees, is smaller than the ratio of areas with other angles, the reflecting light H2 cannot be adequately entered into the light receiving surface J.

Incidentally, although the reflecting surface 100 has microscopic concaved and convex portions, a region until approximately ten times the wave length of the light becomes a scattering region called Mie scattering. Since the range of visible light is between 460 nm to 780 nm, it is possible to obtain the normal line N0 as long as a smoothing process is performed so that the surface with a roughness of less than or equal to 7.8 $\mu$m becomes smooth. It is preferable that the measurement of this normal line N0 be made using a laser microscope. Furthermore, it is possible to use a cross sectional measurement conducted by an optical microscope or an electron microscope. Further, at this time, the sheet normal line NB, which is a normal line to the sheet surface 105, may be regarded as a line perpendicular to a stage on which the light reusing sheet 20 is placed.

Further, when the Gaussian curvature Kg of the light reflecting surface 100 is measured, the Gaussian curvature Kg may be obtained according to Equation 1 above by measuring the curvature K after performing a smoothing process so that the surface with a roughness of less than or equal to 7.8 $\mu$m becomes smooth, in a manner similar to measuring the normal line N0. Incidentally, the minimum value K1 of the curvature K computed by estimating the direction of the curvature K from the shape of the reflecting surface 100 and the maximum value K2 of the curvature K may be used as the minimum value K1 of the curvature K and the maximum value K2 of the curvature K. Here, when the curvature K is less than or equal to the measuring error, the Gaussian curvature Kg is regarded as zero. Incidentally, when the curvature K equals zero, it could be said that there is not curvature K, whereas, when the curvature K is other than zero, it could be said that there is a curvature K.

Further, regardless of the above, whether the Gaussian curvature Kg equals zero may be determined by obtaining a cross section of the sample with a microtome and the like, and by determining whether or not there is a curvature K.

Incidentally, it is possible to obtain the normal line N0 and the Gaussian curvature Kg at multiple points on the reflecting surface 100. However, according to the actual measurement, it is realistic to make a measurement at a pitch of approximately 0.01 mm, and set it as a standard of whether one is within or outside the range of the present invention. When the normal line N0 and the Gaussian curvature Kg are measured at a much finer point, the measurement is not appropriate as a measurement for figuring out the behavior of the reflecting light H2 being reflected at the reflecting surface 100. Further, when a measurement is made at a rougher pitch, the concaved and convex structure of the reflecting surface 100 cannot be adequately measured.

In this way, the reflecting surface 100 is measured from 10 points to 100 points. The ratio of the number of surfaces with a Gaussian curvature Kg of zero may be regarded as the ratio of the area among the reflecting surface 100 with a Gaussian curvature Kg of zero. For example, if the number of points with the Gaussian curvature Kg of zero is 92 points among 100 points, then, it may be said that 92 percent of the reflecting surface 100 is such that the Gaussian curvature Kg equals zero.

Next, the concaved and convex form of the reflecting surface 100 is described using the normal line N0.

Incidentally, the normal line N0 of the reflecting surface 100 is a line perpendicular to a tangential flat surface at an arbitrary point on the reflecting surface 100, and faces a direction parallel to the normal line N of the flat surface P when the light reusing sheet 20 is placed in a stable condition on the flat surface P. In addition, the angle θ of the reflecting surface 100 is an angle between the normal line N0 of the reflecting surface 100 and the sheet normal line NB.

Normally, the sheet normal line NB is placed so as to be parallel to the normal line NG of the incident surface 110. Therefore, the incident light H1 makes an entrance parallel to the sheet normal line NB.

The reflection ratio of the reflecting light H2 varies significantly according to the incident angle into the incident surface 110. FIG. 11 shows a graph indicating a change in the reflection ratio based on the incident angle. As shown in FIG. 11, the reflection ratio changes significantly before and after the critical angle θc. If the refraction index of the front surface board 22 is set to ng, the critical angle θc (deg) may be represented as follows:

$$\theta c = \arcsin (1/ng) \qquad (Equation\ 2)$$

The reflecting light H2 which entered the incident surface 110 at an angle greater than or equal to this critical angle θc makes a total reflection at the incident surface 110.

Furthermore, when the refraction index of the packed bed is set to ne, and the angle with respect to the normal line NG of the reflecting light H2 equals q1 (deg), the following equation holds according to Snell's law:

$$ng \cdot \sin(\theta c) = ne \cdot \sin(q1) \quad \text{(Equation 3)}$$

From Equation 2 and Equation 3, the following equation holds:

$$q1 = \arcsin(1/ne) \quad \text{(Equation 4)}$$

Incidentally, when the packed bed 21 comprises a plurality of layers, and when the refraction index of the material above the reflecting surface 100 equals n0, the following equation holds:

$$q1 = \arcsin(1/n0) \quad \text{(Equation 5)}$$

When the angle of the reflecting surface 100 equals θ (deg), this q1 may be represented as follows:

$$q1 = 2 \cdot \theta \quad \text{(Equation 6)}$$

From above, when the angle θ (deg) of the reflecting surface 100 satisfies the following,

$$2 \cdot \theta = q1 \geq \arcsin(1/n0) \quad \text{(Equation 7)}$$

the reflecting light H2 makes a total reflection. However, usually, the concaved and convex form is not comprised of a single flat surface. As the reflecting surfaces 101, 102 in FIG. 12, the concaved and convex form is comprised of a pair of reflecting surfaces 100. Therefore, when the angle 0 becomes large, the reflecting light makes multiple reflections. When multiple reflections are made, the angle q2 of the reflecting light H22 is ejected at an angle represented by the following equation, not by the above equation.

First, when the reflecting surface 101 is considered to be the surface that the incident light H11 enters upon being incident to the reflecting surface 101, its angle is considered to equal θ1 (deg), the reflecting surface 102 is considered to be the surface at which the light reflecting from the reflecting surface makes a further reflection, its angle is considered to be θ2 (deg), the angle q 12 (deg) of the light entering the reflecting surface 102 equals the following:

$$q12 = 90 - (2 \cdot \theta1 + \theta2 - 90) \quad \text{(Equation 8)}$$

When q12 is greater than or equal to 90 degrees, multiple reflections will not occur.

Further, the angle q2 (deg) of the reflecting light H22 reflecting at the reflecting surface 102 equals the following:

$$q2 \quad = 90 - (2 \cdot \theta1 + \theta2 - 90 + \theta2)$$

$$= 180 - 2 \cdot (\theta1 + \theta2) \quad \text{(Equation 9)}$$

The peak angle α (deg) formed by the reflecting surface 101 and the reflecting surface 102 equals the following:

$$\alpha = 180 - (\theta 1 + \theta 2) \qquad\qquad \text{(Equation 10)}$$

Therefore, using the peak angle α (deg), the following equation holds:

$$q2 = 180 - 2(180 - \alpha) = 2\cdot\alpha - 180 \quad \text{(Equation 11)}$$

Further, similar to the above Equation 7, the condition for a total reflection at the incident surface 110 is as follows:

$$\alpha \geq (\arcsin(1/n0) + 180)/2 \qquad\qquad \text{(Equation 12)}$$

The above description is an explanation of a case in which the incident light H11 enters the reflecting surface 101. However, the Equation 12 also holds in a similar manner in a case in which the incident light H12 enters the reflecting surface 102.

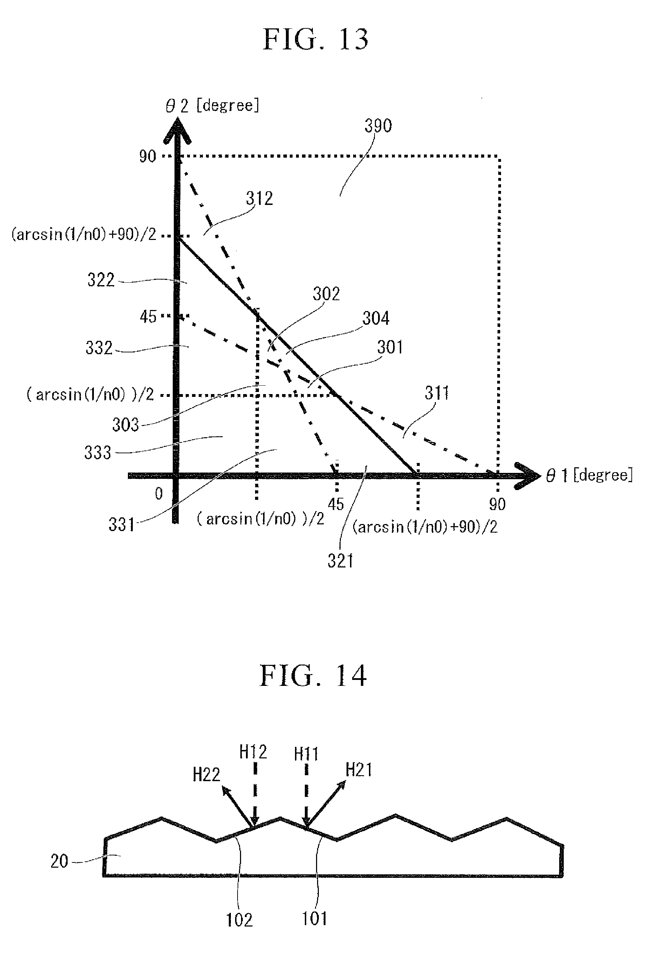

Further, the light reusing sheet according to the present invention is described in detail with reference to FIG. 13. FIG. 13 is a graph showing the angular range of a reflecting surface of a light reusing sheet. The horizontal axis represents the angle θ1 of the reflecting surface 101, while the vertical axis represents the angle θ2 of the reflecting surface 102.

Based on a relationship between the angle θ1 of the reflecting surface 101 and the angle θ2 of the reflecting surface 102, a description is made according to the divided angular regions 301, 302, 303, 304, 311, 312, 321, 322, 331, 332, 333, and 390 in FIG. 12.

FIG. 14 is a cross sectional diagram showing an example of a reflecting surface of a light reusing sheet when the angle θ1 of the reflecting surface 101 and the angle θ2 of the reflecting surface 102 is in the angular range of range 333. The incident light H11 which entered the reflecting surface 101 from the packed bed 21 reflects at the reflecting surface 101, enters the incident surface 110, and is ejected without making a total reflection. On the other hand, the incident light H12 which entered the reflecting surface 102 from the packed bed 21 reflects at the reflecting surface 102, enters the incident surface 110, and is ejected without making a total reflection.

According to the above angular range, the reflecting light H21, H22 which reflected at the reflecting surfaces 101, 102 does not make a total reflection at the incident surface 110. Therefore, the reflecting light H21, H22 cannot be entered to the solar battery cell 30 in an efficient manner. Thus, the above angular range is not a favorable angular range.

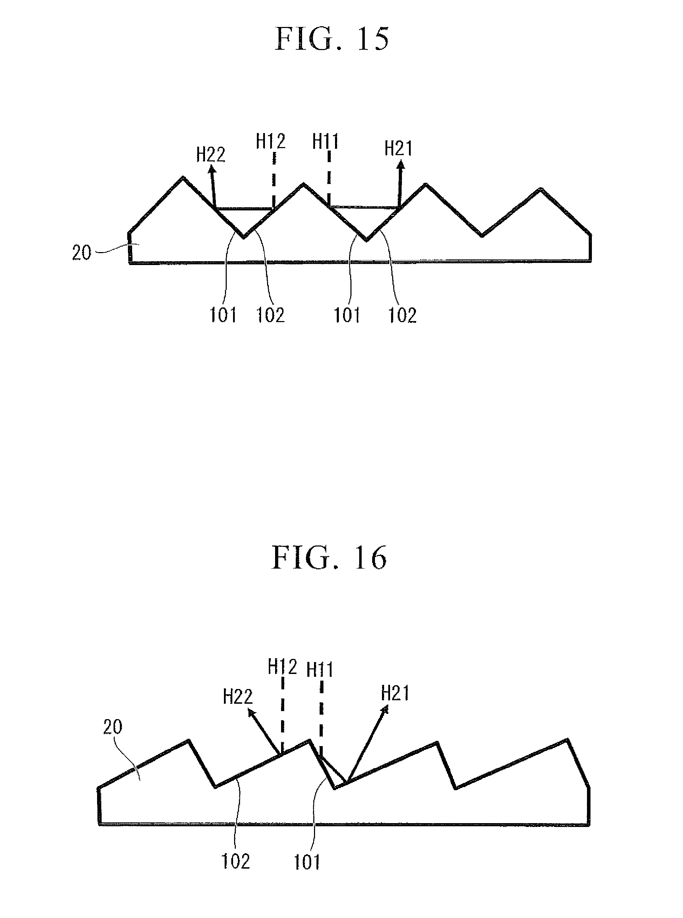

FIG. 15 is a cross sectional diagram showing an example of a reflecting surface of a light reusing sheet when the angle θ1 of the reflecting surface 101 and the angle θ2 of the reflecting surface 102 are in the angular range of region 390. The incident light H11 entering the reflecting surface 101 from the packed bed 21 reflects at the reflecting surface 101, and is ejected towards the reflecting surface 102. Thereafter, a reflection is made at the reflecting surface 102, an entrance is made to the incident surface 110, and an ejection is made without making a total reflection. Meanwhile, the incident light H12 entering the reflecting surface 102 from the packed bed 21 is reflected at the reflecting surface 102, and is ejected towards the reflecting surface 101. Thereafter, a reflection is made at the reflecting surface 101, an entrance is made to the incident surface 110, and an ejection is made without making a total reflection at the incident surface 110.

According to the above angular range, the reflecting light H21, H22 reflecting at the reflecting surface 101, 102 does not make a total reflection at the incident surface 110. Therefore, the reflecting light H21, H22 cannot be entered into the solar battery cell 30 in an efficient manner. Thus, the above angular range is not a favorable angular range.

FIG. 16 is a cross sectional diagram showing an example of a reflecting surface of a light reusing sheet when the angle θ1 of the reflecting surface 101 and the angle θ2 of the reflecting surface 102 are in the angular range of range 311. The incident light H11 which entered the reflecting surface 101 from the packed bed 21 reflects at the reflecting surface 101, and enters the reflecting surface 102. Thereafter, a reflection is made at the reflecting surface 102, an entrance is made into the incident surface 110, and is ejected without making a total reflection. Meanwhile, the incident light H12 which entered the reflecting surface 102 from the packed bed 21 reflects at the reflecting surface 102, enters the incident surface 110, and is ejected without making a total reflection.

According to the above angular range, the reflecting light H21, H22 reflecting at the reflecting surface 101, 102 does not make a total reflection at the incident surface 110. Therefore, the reflecting light H21, H22 cannot be entered efficiently into the solar battery cell 30. Thus, the above angular range is not a favorable angular range.

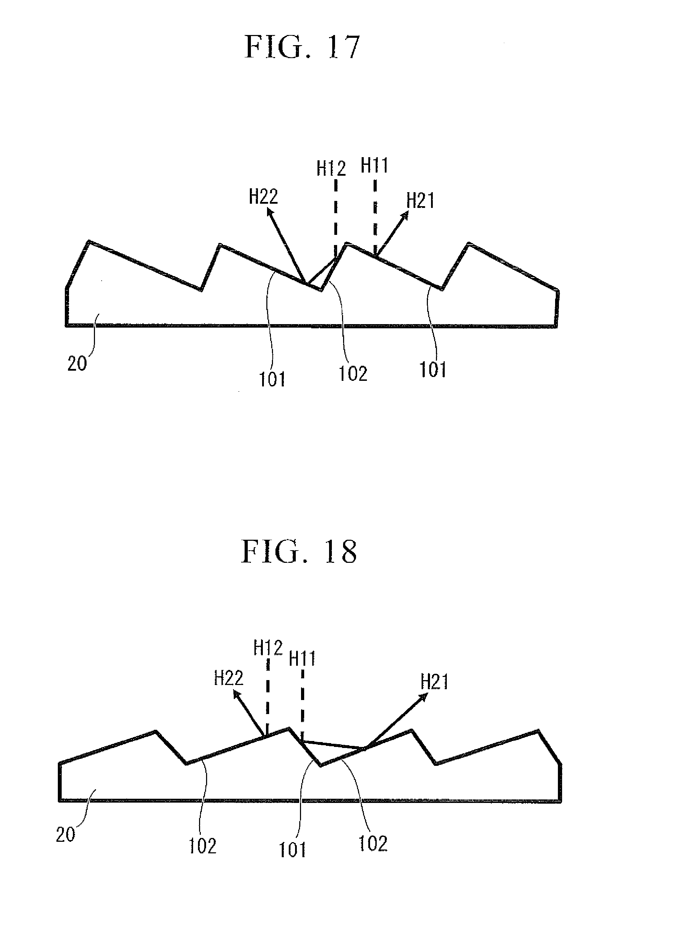

FIG. 17 is a cross sectional diagram showing an example of a reflecting surface of a light reusing sheet when the angle θ1 of the reflecting surface 101 and the angle θ2 of the reflecting surface 102 are in the angular range of range 312. The incident light H11 which entered the reflecting surface 101 from the packed bed 21 reflects at the reflecting surface 102, enters the incident surface 110, and is ejected without making a total reflection. Meanwhile, the incident light H12 which entered the reflecting surface 102 from the packed bed 21 reflects at the reflecting surface 102, and enters the reflecting surface 101. Thereafter, a reflection is made at the reflecting surface 101, an entrance is made to the incident surface 110, and then an ejection is made without making a total reflection.

According to the above angular range, the reflecting light H21, H22 reflecting at the reflecting surface 101, 102 does not make a total reflection at the incident surface 110. Therefore, the reflecting light H21, H22 cannot be entered efficiently into the solar battery cell 30. Thus, the above angular range is not a favorable angular range.

FIG. 18 is a cross sectional diagram showing an example of a reflecting surface of a light reusing sheet when the angle θ1 of the reflecting surface 101 and the angle θ2 of the reflecting surface 102 are in the angular range of range 321. The incident light H11 which entered the reflecting surface 101 from the packed bed 21 reflects at the reflecting surface 101, and enters the reflecting surface 102. Thereafter, a reflection is made at the reflecting surface 102, an entrance is made to the incident surface 110, and a total reflection is made. Meanwhile, the incident light H12 which entered the reflecting surface 102 from the packed bed 21 reflects at the reflecting surface 102, enters the reflecting surface 110, and is ejected without making a total reflection. Thereafter, a reflection is made at the reflecting surface 101, an entrance is made to the incident surface 110, and then an ejection is made without making a total reflection.

According to the above angular range, although the reflecting light H22 of the reflecting surface 102 does not make a total reflection at the incident surface 110, the reflecting light H21 of the reflecting surface 101 makes a total reflection at the incident surface 110. Therefore, the reflecting light H21 may be entered efficiently into the solar battery cell 30. Thus, the above angular range is a favorable angular range.

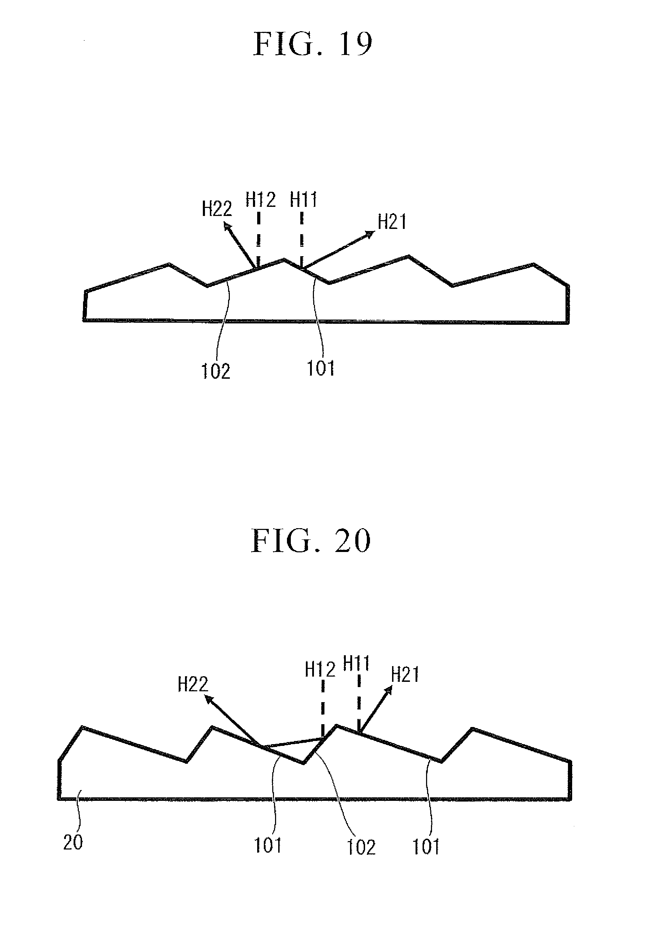

FIG. 19 is a cross sectional diagram showing an example of a reflecting surface of a light reusing sheet when the angle θ1 of the reflecting surface 101 and the angle θ2 of the reflecting surface 102 are in the angular range of range 331. The incident light H11 which entered the reflecting surface 101 from the packed bed 21 reflects at the reflecting surface 101, enters the incident surface 110, and makes a total reflection. Meanwhile, the incident light H12 which entered the reflecting surface 102 from the packed bed 21 enters the incident surface 110, and is ejected without making a total reflection.

According to the above angular range, although the reflecting light H22 of the reflecting surface 102 does not make a total reflection at the incident surface 110, the reflecting light H21 of the reflecting surface 101 makes a total reflection at the incident surface 110. Therefore, the reflecting light H21 may be entered efficiently into the solar battery cell 30. Thus, the above angular range is a favorable angular range.

FIG. 20 is a cross sectional diagram showing an example of a reflecting surface of a light reusing sheet when the angle θ1 of the reflecting surface 101 and the angle θ2 of the reflecting surface 102 are in the angular range of range 322. The incident light H11 which entered the reflecting surface 101 from the packed bed 21 reflects at the reflecting surface 102, enters the incident surface 110, and is ejected without making a total reflection. Meanwhile, the incident light H12 which entered the reflecting surface 102 from the packed bed 21 reflects at the reflecting surface 102, and enters the reflecting surface 101. Thereafter, a reflection is made at the reflecting surface 101, an entrance is made into the incident surface 110, and a total reflection is made.

According to the above angular range, although the reflecting light H21 of the reflecting surface 101 does not make a total reflection at the incident surface 110, the reflecting light H22 of the reflecting surface 102 makes a total reflection at the incident surface 110. Therefore, the reflecting light H22 may be entered efficiently into the solar battery cell 30. Thus, the above angular range is a favorable angular range.

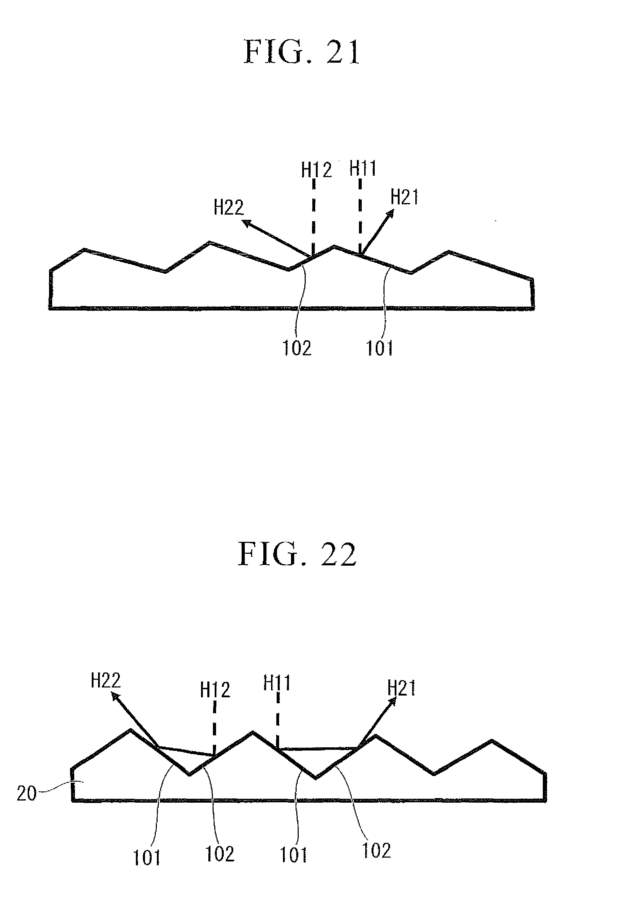

FIG. 21 is a cross sectional diagram showing an example of a reflecting surface of a light reusing sheet when the angle θ1 of the reflecting surface 101 and the angle θ2 of the reflecting surface 102 are in the angular range of range 332. The incident light H11 which entered the reflecting surface 101 from the packed bed 21 reflects at the reflecting surface 102, enters the incident surface 110, and is ejected without making a total reflection. Meanwhile, the incident light H12 which entered the reflecting surface 102 from the packed bed 21 reflects at the reflecting surface 102, enters the reflecting surface 110, and makes a total reflection.

According to the above angular range, although the reflecting light H21 of the reflecting surface 101 does not make a total reflection at the incident surface 110, the reflecting light H22 of the reflecting surface 102 makes a total reflection at the incident surface 110. Therefore, the reflecting light H22 may be entered efficiently into the solar battery cell 30. Thus, the above angular range is a favorable angular range.

FIG. 22 is a cross sectional diagram showing an example of a reflecting surface of a light reusing sheet when the angle θ1 of the reflecting surface 101 and the angle θ2 of the reflecting surface 102 are in the angular range of range 304. The incident light H11 which entered the reflecting surface 101 from the packed bed 21 reflects at the reflecting surface 101, and enters the reflecting surface 102. Thereafter, a reflection is made at the reflecting surface 102, an entrance is made into the incident surface 110, and a total reflection is made. Meanwhile, the incident light H12 which entered the reflecting surface 102 from the packed bed 21 reflects at the reflecting surface 102, and enters the reflecting surface 101. Thereafter, a reflection is made at the reflecting surface 102, an entrance is made into the incident surface 110, and a total reflection is made.

According to the above angular range, the reflecting light H21, H22 reflecting at the reflecting surface 101, 102 makes a total reflection at the incident surface 110. Therefore, the reflecting light H21, H22 may be entered efficiently into the solar battery cell 30. Thus, the above angular range is a further favorable angular range.

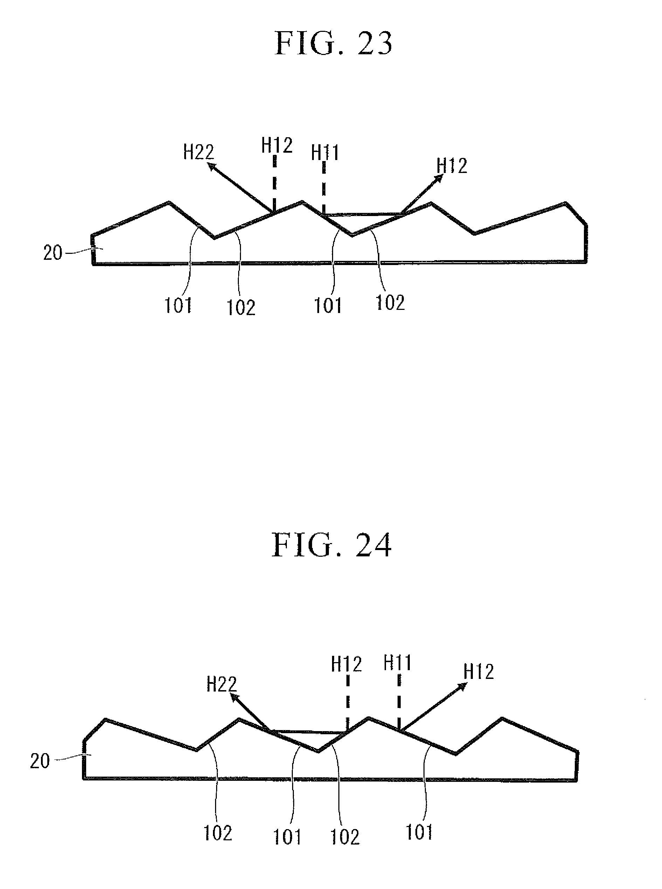

FIG. 23 is a cross sectional diagram showing an example of a reflecting surface of a light reusing sheet when the angle $\theta 1$ of the reflecting surface 101 and the angle $\theta 2$ of the reflecting surface 102 are in the angular range of range 301. The incident light H11 which entered the reflecting surface 101 from the packed bed 21 reflects at the reflecting surface 101, and enters the reflecting surface 102. Thereafter, a reflection is made at the reflecting surface 102, an entrance is made into the incident surface 110, and a total reflection is made. Meanwhile, the incident light H12 which entered the reflecting surface 102 from the packed bed 21 reflects at the reflecting surface 102, enters the incident surface 110, and makes a total reflection.

According to the above angular range, the reflecting light H21, H22 reflecting at the reflecting surface 101, 102 makes a total reflection at the incident surface 110. Therefore, the reflecting light H21, H22 may be entered efficiently into the solar battery cell 30. Thus, the above angular range is a further favorable angular range.

FIG. 24 is a cross sectional diagram showing an example of a reflecting surface of a light reusing sheet when the angle $\theta 1$ of the reflecting surface 101 and the angle $\theta 2$ of the reflecting surface 102 are in the angular range of range 302. The incident light H11 which entered the reflecting surface 101 from the packed bed 21 reflects at the reflecting surface 101, enters the incident surface 110, and makes a total reflection. Meanwhile, the incident light H12 which entered the reflecting surface 102 from the packed bed 21 reflects at the reflecting surface 102, and enters the reflecting surface 101. Thereafter, a reflection is made at the reflecting surface 101, an entrance is made to the incident surface 110, and a total reflection is made.

According to the above angular range, the reflecting light H21, H22 reflecting at the reflecting surface 101, 102 makes a total reflection at the incident surface 110. Therefore, the reflecting light H21, H22 may be entered efficiently into the solar battery cell 30. Thus, the above angular range is a further favorable angular range.

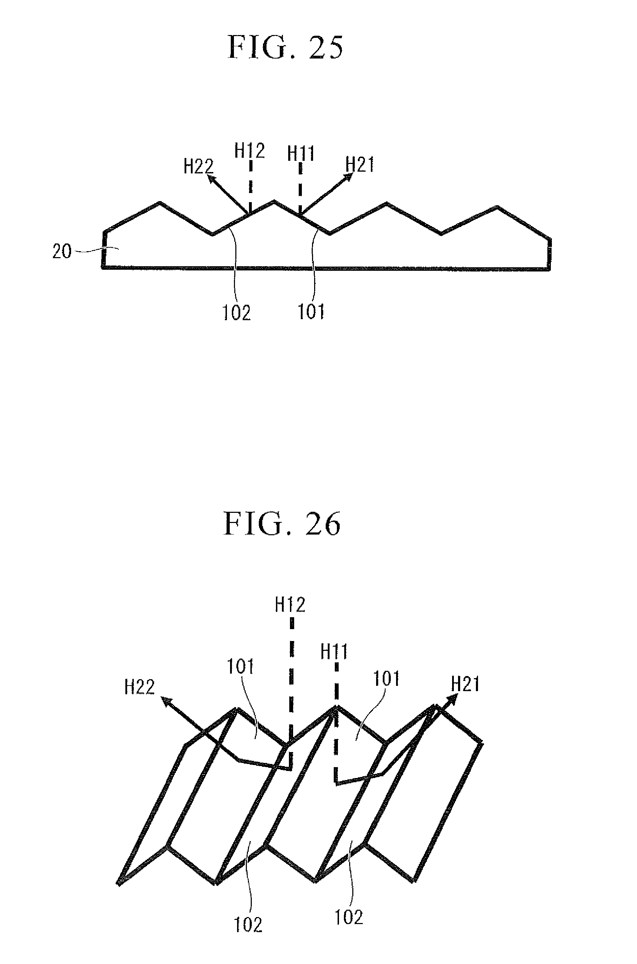

FIG. 25 is a cross sectional diagram showing an example of a reflecting surface of a light reusing sheet when the angle $\theta 1$ of the reflecting surface 101 and the angle $\theta 2$ of the reflecting surface 102 are in the angular range of range 303. The incident light H11 which entered the reflecting surface 101 from the packed bed 21 reflects at the reflecting surface 101, enters the incident surface 110, and makes a total reflection. Meanwhile, the incident light H12 which entered the reflecting surface 102 from the packed bed 21 reflects at the reflecting surface 102, enters the incident surface 110, and makes a total reflection.

According to the above angular range, the reflecting light H21, H22 reflecting at the reflecting surface 101, 102 makes a total reflection at the incident surface 110. Therefore, the reflecting light H21, H22 may be entered efficiently into the solar battery cell 30. Thus, the above angular range is a further favorable angular range.

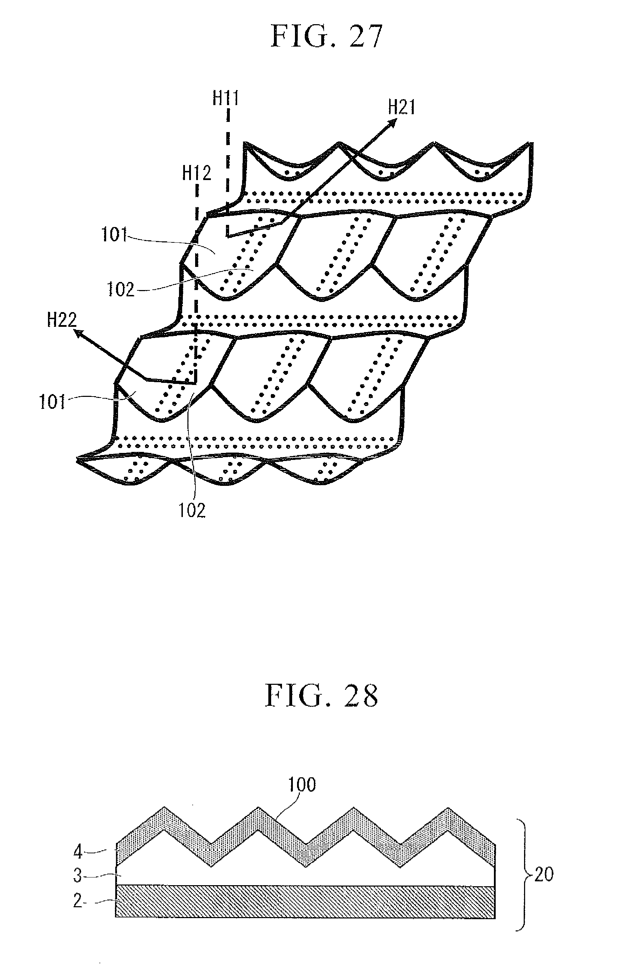

FIGS. 26 and 27 are perspective views showing an example of a reflecting surface of the light reusing sheet according to the present invention. Examples of the reflecting surfaces 101, 102 described above are the perspective views represented in FIGS. 26 and 27. However, the present invention is not particularly limited to these configurations.

Further, among the reflecting surface 100, it is preferable that the ratio of the total area of the reflecting surface 100 satisfying the favorable angles described above be greater than or equal to 50 percent. If, among the reflecting surface 100, the ratio of the total area of the reflecting surface 100 satisfying the favorable angles described above is less than 50 percent, adequate amount of light cannot be entered into the light receiving surface J.

FIG. 28 is a cross sectional view showing an example of the light reusing sheet according to the present invention. The light reusing sheet 20 comprises a substrate 2, a structural layer 3, and a reflecting layer 4. The surface of the reflecting layer 4 is the reflecting surface 100. As a molding for forming the reflecting surface 100, it is possible to use a molding created by a machine cutting. At this instance, as a sloped surface, it is preferable to use one which is in a straight form. In addition, it is preferable that the tip be rounded, because the lens may be easily scratched.

As a method to form a concaved convex structure to the structured layer 3, an example is a method in which a thermoset resin, an ultraviolet curable resin, or an electron beam curable resin is applied or injected to the concaved and convex forming surface of the flat stamper or the roll stamper, place a substrate 2 further on top, and demold from the stamper after a curing process.

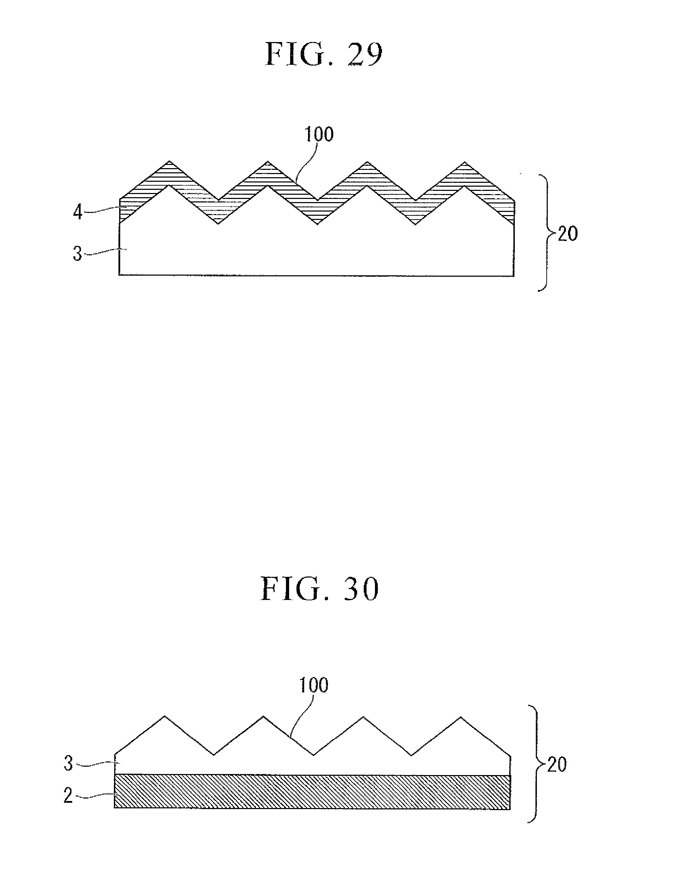

FIG. 29 is a cross sectional view showing an example of a light reusing sheet 20 which comprises only of a structured layer 3 and does not use a substrate 2. As a manufacturing method of a light reusing sheet 20 comprising only of a structured layer 3 without using a substrate 2, as shown in FIG. 29, a method is used in which a structured layer 3 and a substrate 2 are integrally formed according to a press method, a casting method, and an inj ection forming method and the like using a metal molding. In this way, the concaved convex structure is formed at the same time as the sheet formation.

Further, the concaved and convex formed structure of the reflecting surface 100 may comprise a periodic structure. The concaved and convex formed structure of the reflecting surface 100 described above may be a prism-shaped form, may be shaped like various lenses and prisms such as a cylindrical lens, and may be an indefinite form. At this time, it is preferable that the pitch of the period of the concaved and convex structure of the reflecting surface 100 be less than or equal to 300 μm, and it is further preferable that the pitch of the period be less than or equal to 200 μm. When the pitch of the period of the above structure is greater than 300 μm, the mold forming capability is low because sufficient amount of resin does not enter the mold at the tip part of the concaved and convex form when the reflecting surface 100 is molded. When the pitch of the period of the above structure is less than or equal to 200 μm, a molding is possible even if the viscosity of the resin is relatively high. Further, when the pitch of the period of the above structure is too small, it becomes difficult to create a mold. Therefore, it is preferable that the pitch of the period of the above structure be greater than or equal to 25 μm, and it is further preferable that the pitch of the period be greater than or equal to 50 μm. When the pitch of the period of the above structure is less than 25 μm, the time required to cut the metal mold becomes large, the tact becomes low, and the productivity drops. When the pitch of the period of the above structure is less than 50 μm, the resin does not enter the groove properly when the reflecting surface 100 is formed. Therefore, the shape of the tip portion of the concaved and convex form cannot be created as the same as the metal mold.

Further, although the thickness of the structural layer 3 is not specified in particular, an example of the thickness is greater than or equal to 30 μm and less than or equal to 500 μm.

It is preferable that the above manufacturing method be appropriately selected according to the compatibility with the materials described below.

Inside the polymer composition forming the structured layer 3, aside from the polymer composition, it is possible to blend, as appropriate, a scattering reflecting body, a curing agent, a plasticizing agent, a dispersing agent, various leveling agents, an ultraviolet ray absorber, an antioxidant agent, a viscosity modifier, a lubricant agent, and a light stabilizer and the like, for example.

There is no particular limitations on the above polymer composition. Examples include poly (meta) acryl, polyurethane resin, fluorine resin, silicone resin, polyimide resin, epoxy resin, polyethylene resin, polypropylene resin, methacryl resin, polymethylpentene resin, cyclic polyolefin resin, polystyrene resin such as acrylic nitrile- (poly) styrene copolymer (AS resin), acrylic nitrile butadiene styrene copolymer (ABS resin), polyvinyl chloride resin, polycarbonate resin, polyester resin, polyamide resin, polyamide-imide resin, polyallyl naphthalate resin, polysulfone resin, polyphenylene sulfide resin, polyether sulfone resin, polyethylene naphthalate resin, polyetherimide resin, acetal resin, cellulose resin, and the like. One type, two types, or more than two types among these polymers may be blended and used.

Examples of the polyol, which is a raw material of the polyurethane resin described above include a polyol obtained by polymerizing a monomeric component including a hydroxyl unsaturated monomer and a polyester polyol obtained under a hydroxyl-excess condition. These may be used either in a monomer form or by blending two or more types of these.

Examples of the hydroxyl unsaturated monomer include (a) a hydroxyl unsaturated monomer such as an acrylic acid 2 - hydroxyethyl, an acrylic acid 2 - hydroxypropyl, a methacrylic acid 2 - hydroxyethyl, a methacrylic acid 2 - hydroxypropyl, an allyl alcohol, a homoallylic alcohol, a cinnamyl alcohol, a crotonyl alcohol, and the like for instance; (b) a divalent alcohol or an epoxy compound such as an ethylene glycol, an ethylene oxide, a propylene glycol, a propylene oxide, a butylene glycol, a butylene oxide, a 1, 4 - bis (hydroxymethyl) cyclohexane, a phenylglycidylether, a glycidyl decanoate, a placcel FM-1 (manufactured by Daicel Chemical Industries Ltd.), for instance; and a hydroxyl unsaturated monomer obtained by a reaction with an unsaturated carboxylic acid such as an acrylic acid, a methacrylic acid, a maleic acid, a fumaric acid, a crotonic acid, an itaconic acid, and the like, for instance. It is possible to manufacture a polyol by polymerizing one type, two types or more than two types selected from these hydroxyl unsaturated monomer.

In addition, the above polyol may be manufactured by polymerizing a hydroxyl unsaturated monomer selected from (a) and (b) above, with one type, two types or more than two types of the following: ethylene unsaturated monomer selected from the following: an ethyl acrylate, an n - propyl acrylate, an isopropyl acrylate, an n - butyl acrylate, a tert - butyl acrylate, an ethylhexyl acrylate, an ethyl methacrylate, an n - propyl methacrylate, an isopropyl methacrylate, an n - butyl methacrylate, a tert - butyl methacrylate, an ethylhexyl methacrylate, a glycidyl methacrylate, a cyclohexyl methacrylate, a styrene, a vinyl toluene, a 1- methylstyrene, an acrylic acid, a methacrylic acid, an acrylic nitrile, a vinyl acetate, a vinyl propionate, a vinyl stearate, an allyl acetate, an adipoyl diallyl, a diallyl itaconate, a diethyl maleate, a vinyl chloride, a vinylidene chloride, an acrylamide, an N - methylol acrylamide, an N - butoxymethyl acrylamide, a diacetone acrylamide, an ethylene, a propylene, an isoprene, and the like.

The number average molecular weight of the polyol obtained by polymerizing a monomeric component including a hydroxyl unsaturated monomer is greater than or equal to 1000 and is less than or equal to 500000, and is more preferably greater than or equal to 5000 and is less than or equal to 100000. In addition, its hydroxyl number is greater than or equal to 5 and is less than or equal to 300, and is more preferably greater than or equal to 10 and is less than or equal to 200, and is even more preferably greater than or equal to 20 and is less than or equal to 150.

A polyester polyol obtained under a hydroxyl-excess condition may be obtained by reacting (c) polyhydroxylic alcohol such as ethylene glycol, diethylene glycol, propylene glycol, dipropylene glycol, 1,3 - butanediol, 1,4 - butanediol, 1,5-pentanediol, neopentyl glycol, hexamethylene glycol, decamethylene glycol, 2, 2, 4 - trimethyl - 1, 3 - pentanediol, trimethylolpropane, hexanetriol, glycerin, pentaerythritol, cyclohexanediol, hydrogenerated bisphenol A, bis (hydroxymethyl) cyclohexane, hydroquinonebis (hydroxyethyl ether), tris (hydroxyethyl) isocyanurate, xylylene glycol, and the like for instance; and (d) polybasic acid such as maleic acid, fumaric acid, succinic acid, adipic acid, sebacic acid, azelaic acid, trimellitate, terephthalic acid, phthalic acid, isophthalic acid, and the like for instance; under the condition that the number of hydroxyl groups in polyhydroxylic alcohol, such as propanediol, hexanediol, polyethyleneglycol, trimethylolpropane, and the like is larger than the number of carboxyl groups in the above polybasic acid.

The number average molecular weight of the polyester polyol obtained under the above hydroxyl-excess condition is greater than or equal to 500 and is less than or equal to 300000, and is more preferably greater than or equal to 2000 and is less than or equal to 100000. In addiction, its hydroxyl number is greater than or equal to 5 and is less than or equal to 300, and is more preferably greater than or equal to 10 and is less than or equal to 200, and is even more preferably greater than or equal to 20 and is less than or equal to 150.

As a polyol used as a polymer material of the polymer composition, it is preferable to use the above polyester polyol, and an acrylic polyol obtained by polymerizing a monomeric component including the above hydroxyl unsaturated monomer and includes a (meta) acrylic unit and the like. When the above polyester polyol or the acrylic polyol are used as a polymer material, it is possible to attain a high level of antiweatherability, and prevent the structural layer 3 from turning yellow. Incidentally, either one of the polyester polyol or the acrylic polyol may be used. Both of the polyester polyol and the acrylic polyol may be used as well.

Incidentally, the number of the hydroxyl groups inside the polyester polyol and the acrylic polyol is not particularly limited when the number is greater than or equal to two per molecule. However, when the number of the hydroxyl groups inside the solid content is less than or equal to 10, the number of crosslinking points tend to decrease, and characteristics of the coated layer such as the solvent resistance, the water resistance, the heat resistance, the surface hardness, and the like tend to decrease.

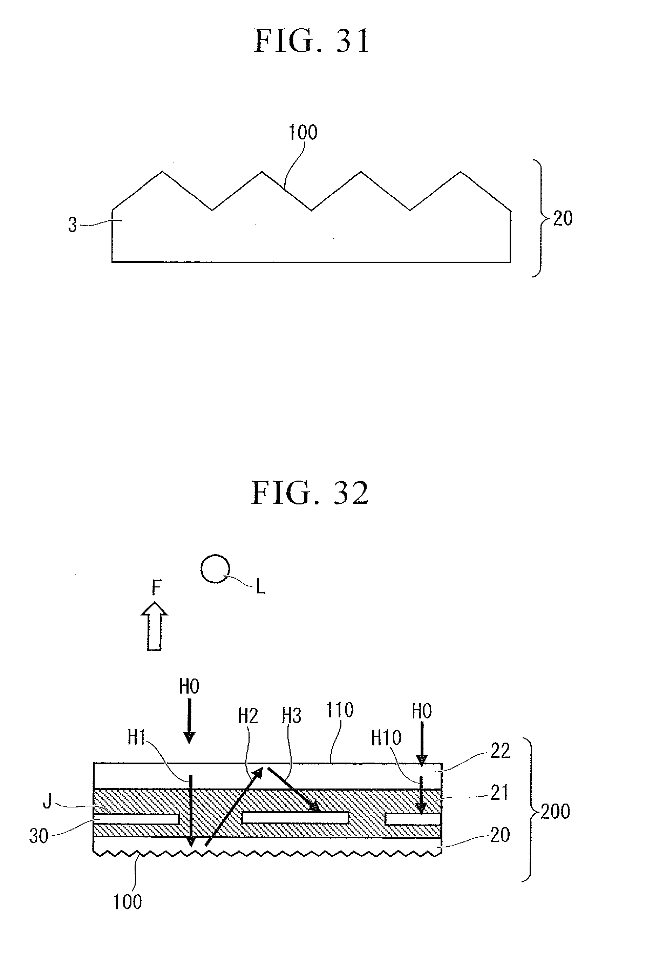

In order to enhance the reflective performance and the heat resistance performance, it is preferable to include a scattering reflector inside a polymer composition forming the structured layer 3. By including the scattering reflector inside the polymer composition, it is possible to enhance the heat resistance of the structured layer 3 and the light reusing sheet 20. At the same time, when a scattering reflector with a refraction index significantly different from the polymer composition is used, light may be reflected. Incidentally, when a sufficient reflection ratio is obtained as a result, it is not necessary to provide a metal reflecting layer 4. FIGS. 30 and 31 are diagrams representing an example of a light reusing sheet 20 when the metal reflecting layer 4 is not provided. An inorganic material comprised in the scattering reflecting agent is not limited in particular, and an inorganic oxide is preferable. A silica and the like may be used as the inorganic oxide. Although a metallic compound such as ZnS may be used as well, it is preferable to use a metallic oxide in particular such as $TiO_2$, ZrO, $Al_2O_3$, and the like. Further, it is possible to use a hollow particle of silica. Among these, it is more preferable to use $TiO_2$ because the refraction index is high, and dispersibility may be obtained. Further, the shape of the scattering reflector may be an arbitrary particle shape such as a spherical shape, a needle shape, a plate shape, a scale shape, a crushed shape, and the like, and is not particularly limited.

A preferable lower limit of the average particle diameter of the scattering reflector is 0.1 $\mu$m. A preferable upper limit is 30 $\mu$m. When the average particle diameter is smaller than 0.1 $\mu$m, light is not adequately reflected. Further, when the average particle diameter is greater than 30 $\mu$m, the molding property is poor.

A preferable lower limit of the blending amount with respect to 100 pieces of the polymer composition of the scattering reflector is 30 pieces in solid content conversion. Meanwhile, a preferable upper limit of the above blending amount of the scattering reflector is 100 pieces. Here, when the blending amount of the inorganic filler is less than 30 pieces, the light H1 entering the structured layer 3 from the packed bed 21 cannot be adequately reflected. On the other hand, when the blending amount exceeds the above range, the molding property is poor.

As the scattering reflector, one with an organic polymer fixed on its surface may be used. By using a scattering reflector with a fixed organic polymer in this way, it is possible to enhance the dispersing property in the polymer composition and to enhance the compatibility with the polymer composition. Regarding this organic polymer, there is no specific limitation on its molar weight, shape, composition, and whether or not there is a functional group. Thus, a random organic polymer may be used. Further, regarding the shape of the organic polymer, an organic polymer with a random shape may be used, such as a straight-chain form, a branching form, a cross-linked structure, and the like.

An example of a specific resin comprised in the above organic polymer includes a polyolefin such as a (meta) acrylic resin, a polystyrene, a polyvinyl acetate, a polyethylene, a polypropylene, and the like; a polyester such as a polyvinyl chloride, a polyvinylidene chloride, a polyethylene terephthalate, and the like; as well as the copolymer of these, and resin such that a denaturation is made on a part of a functional group such as an amino group, an epoxide group, a hydroxy group, a carboxyl group, and the like. Among these, one that requires as a component an organic polymer including a (meta) acrylic unit such as a (meta) acrylic resin, a (meta) acrylic styrene resin, a (meta) acrylic polyester resin, possess a coated layer forming capability and is therefore preferable. Meanwhile, a resin possessing a compatibility with the above polymer composition is preferable. Therefore, one having the same composition as the polymer composition is the most preferable.

As the above polymer composition, polyol comprising a cycloalkyl group is preferable. By injecting a cycloalkyl group inside the polyol as a polymer composition, the hydrophobicity of the polymer composition such as the water repellency, water resistance, and the like increases. As a result, there is an improvement in the deflection resistance characteristic, dimensional stability, and the like of the structural layer 3 and the light reusing sheet 20 under conditions of high temperature and high humidity. Further, the basic coating property of the structured layer 3 such as the antiweatherability, firmness, glossiness, solvent resistance, and the like. Furthermore, there is a further improvement in the compatibility with a scattering reflector, an organic polymer fixed on its surface, as well as the dispersibility of the scattering reflector.

Further, it is preferable to include an isocyanate in the polymer composition as a hardening agent. By including an isocyanate hardening agent in the polymer composition in this way, the cross-linked structure becomes even more robust. Therefore, the coated layer characteristic of the structured layer 3 is further improved. As this isocyanate, a substance similar to the above multifunctional isocyanate compound is used. Above all, an aliphatic isocyanate, which prevents the coating film from turning yellow, is preferable.

Incidentally, the scattering reflector may include an organic polymer in the inside. As a result, it is possible to confer an appropriate consistency and toughness to the inorganic substance which is a core of the scattering reflector.

As the above organic polymer, it is preferable to use one including an alkoxy group. Although there is no particular limitation on the contained amount, it is preferable that the contained amount per one gram of scattering reflector be greater than or equal to 0.01 mmol and less than or equal to 50 mmol. Due to the alkoxy group, it is possible to enhance the compatibility with a polymer composition as well as the dispersibility inside the polymer composition.

The alkoxy group represents an RO group bonded with a metallic element forming a microparticle framework. This R is an alkyl group which may be substituted. The RO group inside the microparticle may be the same or may be different. A specific example of R is methyl, ethyl, n - propyl, isopropyl, n - butyl, and the like. It is preferable to use a metallic alkoxy group which is the same as a metal comprised in the scattering reflector. When the scattering reflector is a colloidal silica, it is preferable to use an alkoxy group such that silicon is the metal.

There is no particular limitation on the content percentage of the organic polymer of the scattering reflector such that the organic polymer is fixed. However, it is preferable that the content percentage be greater than or equal to 0.5 percent by mass and less than or equal to 50 percent by mass, with the scattering reflector being the base.

According to the light reusing sheet 20, when the reflecting layer 4 is used, it is preferable to perform a surface processing to the vapor deposition target surface (the surface of the structured layer 3) of the reflecting layer 4 in order to enhance its close adhesiveness and the like (not diagrammed). Examples of such surface processing include, for example, (a) a corona discharge treatment, an ozone treatment, a low temperature plasma treatment using oxygen gas or nitrogen gas and the like, a glow discharge treatment, an oxidizing treatment using a chemical agent and the like, and (b) a primer coat treatment, an undercoat treatment, an anchor coat treatment, and a vapor deposition anchor coat treatment and the like. Among these surface treatments, a corona discharge treatment and the anchor coat treatment, which leads to an improvement in the adhesive strength with the reflecting layer 4, and thus contributes to the formation of a tight and even reflecting layer 4, are preferred.

Examples of the anchor coating agent used in the anchor coat treatment includes, for example, a polyester anchor coating agent, a polyamide anchor coating agent, a polyurethane anchor coating agent, an epoxy anchor coating agent, a phenol anchor coating agent, a (meta) acrylic anchor coating agent, a polyvinyl acetate series anchor coating agent, a polyolefin type anchor coating agent such as a polyethylene or polypropylene, a cellulosic anchor coating agent, and the like. Among these anchor coating agents, a polyester anchor coating agent, which further enhances the adhesive strength of the reflecting layer 4, is especially preferred.

A preferable coating amount (solid content conversion) of the above anchor coating agent is greater than or equal to 1 g/m$^2$, and is less than or equal to 3 g/m$^2$. When the coating amount of the anchor coating agent is less than 1 g/m$^2$, there is a decrease in the effect of enhancing the tight adhesiveness with the reflecting layer 4. Meanwhile, when the coating amount of the anchor coating agent is greater than 3 g/m$^2$, the strength, durability, and the like of the light reusing sheet 20 may decline.

Incidentally, in the above anchor coating agent, it is possible to blend, as appropriate, various additive agents such as a silane coupling agent in order to enhance the close adhesiveness, an antiblocking agent to prevent blocking, an ultraviolet absorbing agent in order to enhance the antiweatherability, and the like. The preferable blending amount of such an additive agent is greater than or equal to 0.1 % by weight and is less than or equal to 10 % by weight considering the balance between the exhibition of the effect of the additive agent and the functional inhibition of the anchor coating agent. When the above additive agent is less than 0.1 % by weight, blocking cannot be adequately prevented, and thus, antiweatherability cannot be adequately achieved. When the above additive agent is greater than 10 % by weight, the features of the top coating agent are obstructed.

The reflecting layer 4 reflects light entering the light reusing sheet 20. When the reflecting layer 4 is formed, the formation is made by vapor-depositing metal along a surface on which a concaved and convex structure of the structured layer 3 is formed. The method of vapor-depositing to the reflecting layer 4 is not limited in particular, as long as metal may be vapor-deposited without causing a deterioration of the structured layer 3 such as a contraction, a yellowing, and the like. Examples which are used include (a) a physical vapor deposition method (Physical Vapor Deposition Method; PVD Method) such as a vacuum vapor deposition method, a sputtering method, an ion plating method, an ion cluster beam method, and the like, as well as (b) a chemical vapor deposition method (Chemical Vapor Deposition Method; CVD Method) such as a plasma chemical vapor deposition method, a thermochemistry vapor deposition method, a photochemistry vapor deposition method, and the like. Among these vapor deposition methods, the vacuum vapor deposition method and the ion plating method are preferred because a productive and high-quality reflecting layer 4 may be formed.

Regarding the metal used in the reflecting layer 4, there is no particular limitation as long as a metallic glow is present and a vapor deposition may be made. Examples include aluminum (Al), silver (Ag), nickel (Ni), tin (Sn), zirconium (Zr), and the like. Among these, aluminum is preferable because the reflectivity is high, and a compact reflecting layer 4 may be formed relatively easily.

Incidentally, the reflecting layer 4 may be a single layered structure, or a multi-layered structure with two or more layers. By making the reflecting layer 4 a multi-layered structure, it is possible to reduce the deterioration of the structured layer 3 by lessening the heat load imposed during vapor deposition. Further, it is possible to improve the adhesiveness of the structured layer 3 and the reflecting layer 4. At this time, an oxidized metallic layer may be provided on top of the metallic layer. Further, the condition of the vapor deposition during the above physical vapor deposition method and the chemical vapor deposition method is configured appropriately according to the type of the resin of the structured layer 3 and the base material 2, as well as the thickness of the reflecting layer 4.

10 nm is the preferred lower limit of the thickness of the reflecting layer 4, and 20 nm is particularly preferred. Meanwhile, 200 nm is the preferred upper limit of the thickness of the reflecting layer 4, and 100 nm is particularly preferred. When the thickness of the reflecting layer 4 is smaller than the 10 nm lower limit, it is not possible to adequately reflect the light entering the reflecting layer 4 from the packed bed 21. In addition, even with a thickness greater than or equal to 20 nm, the amount of light which is reflected at the above reflecting layer 4 does not increase. Therefore, 20 nm is considered to be an adequate thickness. Meanwhile, when the thickness of the reflecting layer 4 exceeds the 200 nm upper limit, a visible and recognizable crack is created in the reflecting layer 4. If the thickness is less than or equal to 100 nm, even an invisible crack is not created.

Further, at an exterior surface of the reflecting layer 4, it is preferable to apply a top coating processing (not diagrammed). By applying a top coating processing to the outer surface of the reflecting layer 4 in this way, the reflecting layer 4 is sealed and protected. As a result, the handling property of the optical reusing sheet 20 is enhanced. Further, it is possible to prevent the reflecting layer 4 from deteriorating due to the passage of time.

Examples of the top coating agent used in the top coating processing include a polyester top coating agent, a polyamide top coating agent, a polyurethane top coating agent, an epoxy top coating agent, a phenolic top coating agent, a (meta) acrylic top coating agent, a polyvinyl acetate top coating agent, a polyolefin top coating agent such as polyethylene or polypropylene, and a cellulose top coating agent. Among such top coating agents, a polyester top coating agent is particularly preferable because of its high adhesive strength with the reflecting layer 4, and because it contributes to the protection of the surface of the reflecting layer 4 as well as the sealing of imperfections.

The preferred amount of coating (in terms of solid content) is greater than or equal to 3 $g/m^2$ and less than or equal to 7 $g/m^2$. If the amount of coating of the top coating agent is less than 3 $g/m^2$, there may be reduced effects of sealing and protecting the reflecting layer 4. Meanwhile, even if the amount of coating of the top coating agent exceeds 7 $g/m^2$, the effect of sealing and protecting the reflecting layer 4 is not significantly enhanced. On the other hand, the thickness of the light reusing sheet 20 increases.

Incidentally, it is possible to blend into the top coating agent, as appropriate, various additives such as a silane coupling agent to enhance adhesiveness, an ultraviolet ray absorbing agent to enhance antiweatherability, an inorganic filler to enhance heat resistance, and the like. The amount of the additive blended is preferably greater than or equal to 0.1 percent by weight, and less than or equal to 10 percent by weight, according to a balance between the realization of the effect of the additive and the extent to which the function of the top coating agent is hindered. If the amount of the additive is less than 0.1 percent by weight, it is not possible to obtain an adequate level of close adhesiveness, antiweatherability, and heat resistance. If the amount of the additive is greater than 10 percent by weight, the function of the top coating agent is hindered.

The base material 2 comprised in the above light reusing sheet 20 is formed by a sheet molding having synthesized resin as a raw material. As a synthesized resin used in the base material 2, it is preferable to use a synthesized resin having antiweatherability such as water resistance and durability against ultraviolet rays considering that it will be placed outdoors. Examples include a polyethylene resin such as polyethylene terephthalate resin (PET resin) and the like, a polypropylene resin, a methacryl resin, a polymethylpentene resin, a cyclic polyolefin resin, a polystyrene resin, an acrylic nitrile - (poly) styrene copolymer (AS resin), an acrylic nitrile - butadiene styrene copolymer (ABS resin), a polyvinyl chloride resin, a fluorine resin, a poly (meta) acrylic resin, a polycarbonate resin, a polyester resin, a polyamide resin, a polyimide resin, a polyamide-imide resin, a polyallyl phthalate resin, a silicon resin, a polysulfone resin, a polyphenylene sulfide resin, a polyether sulfone resin, a polyethylene naphthalate resin, a polyetherimide resin, an epoxy resin, a polyurethane resin, an acetal resin, a cellulose resin, and the like.

Among these resin, a polyimide resin, a polycarbonate resin, a polyester resin, a fluorine resin, and a polylactate resin is preferable, because of their high heat resistance, strength, antiweatherability, durability, gas barrier capabilities against vapor, and the like.

Examples of such polyester resin includes polyethylene terephthalate, polyethylene naphthalate, and the like. Among these polyester resins, a polyethylene terephthalate is particularly preferable because it is well balanced in terms of expensiveness and various functions such as heat resistance and antiweatherability.

Examples of the above fluorine resin includes polytetrafluoroethylene (PTFE), a perfluoro alkoxi resin (PFA) comprising a copolymer of tetrafluoroethylene and perfluoro alkyl vinyl ether, a copolymer (FEP) of tetrafluoroethylene and hexafluoropropylene, a copolymer (EPE) of tetrafluoroethylene and perfluoro alkyl vinyl ether and hexafluoropropylene, a copolymer (ETFE) of tetrafluoroethylene and ethylene or propylene, a polychloro trifluoro ethylene resin (PCTFE), a copolymer (ECTFE) of ethylene and chloro trifluoro ethylene, a vinylidene fluoride resin (PVDF), vinyl fluoride resin (PVF), and the like. Among these fluorine resin, a poly vinyl fluoride resin (PVF), a copolymer (ETFE) of tetrafluoroethylene and ethylene or propylene are particularly preferable because of their excellent strength, heat resistance, and antiweatherability.

Examples of the above cyclic polyolefin resin include (d) a polymer obtained by polymerizing cyclic diene such as cyclopentadiene (and its derivative), dicyclopentadiene (and its derivative), cyclohexadiene (and its derivative), norbornadiene (and its derivative), and the like; and (e) a copolymer and the like obtained by copolymerizing the above cyclic diene with one type, two types, or more than two types of the following: olefin monomer such as ethylene, propylene, 4-methyl-1-pentene, styrene, butadiene, isoprene. Among these cyclic polyolefin resin, a cyclic diene polymer such as cyclopentadiene (and its derivative), dicyclopentadiene (and its derivative), or norbornadiene (and its derivative), and the like are particularly preferable because of their excellent strength, heat resistance, and antiweatherability.

Incidentally, as an ingredient to form the base material 2, it is possible to use a mixture of one type, two types, or more than two types of the above synthetic resin. Incidentally, inside the ingredient to form the base material 2, it is possible to blend various additives and the like for the purpose of improving and reforming the workability, heat resistance, antiweatherability, mechanical characteristics, and dimension stability. Examples of such additives include, a lubricant, a cross-linker, an antioxidant, an ultraviolet ray absorbing agent, a photostabilizing agent, a filling material, a reinforcing fiber, a reinforcing agent, a charging prevention agent, a flame retardant, a flame proof agent, a foaming agent, a fungicide, a colorant, and the like. There is not particular limitation on the method of forming the above base material 2. Examples include an extrusion method, a cast forming method, a T dye method, a cutting method, an inflation method, and the like, which are well known methods.

When the base material 2 is used, the thickness is preferably greater than or equal to 25 $\mu$m, and less than or equal to 500 $\mu$m. A thickness of 250 $\mu$m is particularly preferable. When the thickness of the base material 2 is less than 25 $\mu$m, a curl occurs when the structured layer 3 is being coated and processed, due to the influence of the hardening and contracting of the ultraviolet cured resin and the like. Thus, problems arise while assembling to the solar battery module 200. On the contrary, when the thickness of the base material 2 exceeds 500 $\mu$m, the film mass increases, thereby leading to an increase in the mass of the solar battery module 200. If the thickness of the base material 2 is less than or equal to 250 $\mu$m, a lighter weighted solar battery module 200 may be created.

Further, in the base material 2 and the structured layer 3, it is possible to include a polymer obtained by bonding the ultraviolet ray stabilizing base to the ultraviolet ray stabilizing agent or the molecular chain. Due to this ultraviolet ray stabilizing agent or the ultraviolet ray stabilizing base, the radical, active oxygen, and the like generated by the ultraviolet ray is inactivated, thereby enhancing the ultraviolet ray stability, antiweatherability, etc., of the light reusing sheet 20. As this ultraviolet ray stabilizing agent or the ultraviolet ray stabilizing base, it is preferable to use a hindered amine series ultraviolet ray stabilizing agent or a hindered amine series ultraviolet ray stabilizing base.

According to the solar battery module 200 using the light reusing sheet 20 as configured above, a light entering the region R between adjacent solar battery cells 30 is reflected at the reflecting surface 100 of the light reusing sheet 20. Further, it is possible to make the like enter the solar battery cell 30. As a result, it is also possible to use the light entering the region R between adjacent solar battery cells 30. In this way, the efficiency of generating electricity by the solar battery module 200 may be enhanced.

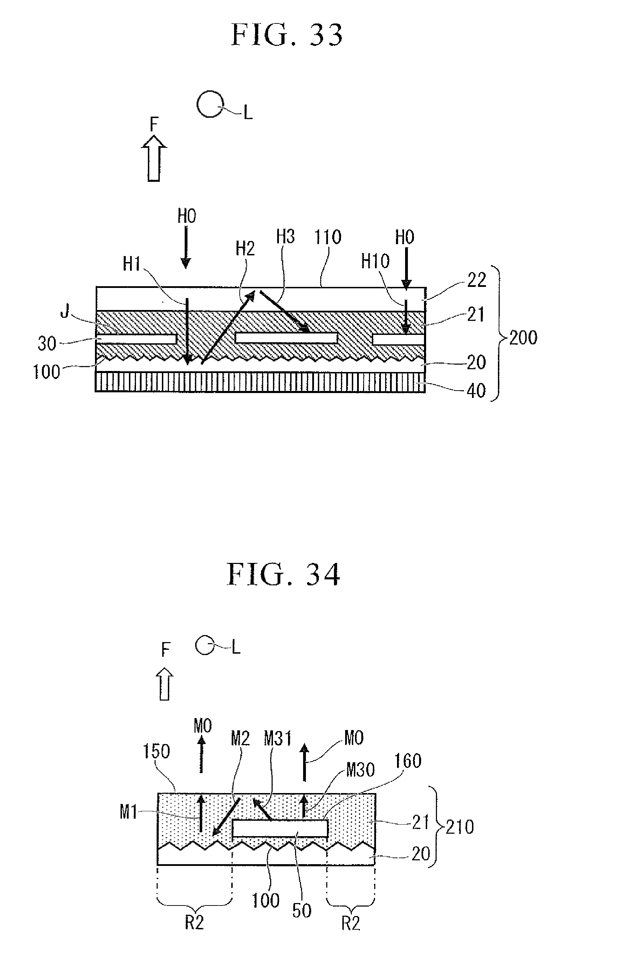

FIGS. 32 and 33 are cross sections indicating an example of the solar battery module according to the present invention. The light reusing sheet 20 may also be placed, as shown in FIG. 32, so that the back surface of the reflecting surface 100 of the light reusing sheet 20 faces the packed bed 21.

Further, as indicated in FIG. 33, it is possible to use as this light reusing sheet 20, an aluminum layer of 10 $\mu$m to 30 $\mu$m, or one comprising a barrier layer including a silica layer of 10 nm to 100 nm. Further, in order to enhance the durability, the solar battery module 200 may be protected by pasting together a PVF (poly fluoride vinyl resin) with a protecting layer 40 comprising an application or with a film 40 comprising a poly fluoride vinyl resin. In this way, the solar battery module 200 may also be used as a back sheet.

This light reusing sheet 20 may also be used to reuse light from a solid illuminating element 50 such as LED, EL, and the like. FIG. 34 is a cross sectional view of an aspect of the light source module 210 according to the present invention using a light reusing sheet 20 reusing light from a solid illuminating element 50 such as LED, EL, and the like. The light source module 210 comprises a packed bed, an illuminating element 50, and a light reusing sheet 20.

The illuminating element 50 converts electricity into light according to an electroluminescence, and emits light from the illuminating surface 160. As the illuminating element 50, a solid luminescent diode such as LED, organic EL, inorganic EL, and the like are preferably used.

The packed bed 21 seals the illuminating element 50. Light emitted from the illuminating element 50 passes through the packed bed 21. Part of the light becomes an ejecting light M30 ejected from the ejection surface 150, while part of the light becomes a reflecting light M31 reflecting at the ejection surface 150. As a raw material of the packed bed 21, a material with a high light transmittance is used so that the light M3 entering the packed bed 21 may be transmitted. An acrylic resin and the like with high permeability is favorably used.

Among the light ejected from the illuminating element 50, the light M31 reflecting at the ejection surface 150 reflects at the ejection surface 150, and enters the reflecting surface 100 of the light reusing sheet 20. The entering light M2 entering the reflecting surface reflects at the reflecting surface 100, and enters the ejection surface 150. The reflecting light M1 reflecting at the reflecting surface 100 and entering the ejection surface 150 ejects outwards from the ejection surface 150. As a result, compared with a configuration in which there is no light reusing sheet 20, it is possible to enhance the efficiency of reusing light.

The direction in which the reflecting light M1 proceeds may be controlled by the concaved and convex shape of the reflecting surface 100 according to the present invention. Since the angular range of the reflecting surface 100 satisfies the above equations 7 and 12, a large amount of the reflecting light M1 may be ejected from the ejection surface 150 as ejected light M0.

(First Working Example)

As a first working example, a polycarbonate resin, which is a thermoplastic resin, is heated to approximately 300 °C, and, by stretching it along a roll, a film with a thickness of 0.3 mm is formed. Thereafter, a cylinder metallic mold is used, such that the shape of the first concaved and convex structure is cut out, and the heated film is cooled (the cylindrical metallic mold itself is 80 °C) while applying pressure. Before a film molded with the shape of the first concaved and convex structure is completely hardened, the film is next cooled while applying pressure with a cylinder metallic mold such that the shape of the second concaved and convex structure is cut out. (The temperature of the cylinder metallic mold with the shape of the second lens array 5 being cut out is 10 °C according to the water cooling type roll.) In this way, a complete hardening is achieved by further lowering the viscosity of the thermoplastic resin. According to the light reusing sheet 20 created by this method, the shape of the light reusing sheet 20 is formed so as to comprise a first concaved and convex structure of a lenticular lens form so that the angle of the reflecting surface 100 with a pitch of 120 $\mu$m comprises a portion with 30 degrees, as well as a second concaved and convex structure of a triangular prism form such that the peak is round and the angle of the reflecting surface 100 with a pitch of 30 $\mu$m comprises a portion with 30 degrees so as to cross orthogonally with the longitudinal direction of the concaved and convex structure. By creating a metallic roll for the cooling roll, having a shape comprising the first concaved and convex structure and the second concaved and convex structure. As a result, the structured layer 3 could be created at once according to an extrusion system by a roll-to-roll (the sending velocity of the film being equal to 1 m/min) configuration. When the surface shape of this light reusing sheet 20 was measured with a confocal scanning laser microscope OLS1100 with 100 points at a 15 $\mu$m pitch, the Gaussian curvature Kg became zero at all points. At 62 points, the angle of the reflecting surface 100 became 22.5 degrees to 30 degrees.

Further, the reflecting layer 4 was created on its top by applying approximately 20 nm of aluminum via vapor deposition. Further, when this light reusing sheet 20 created as described above was measured with Easy Contrast (view angle measuring device), a light distribution which is approximately the same as shown in FIG. 8E was obtained.

(Second Working Example)

As a second working example, a polycarbonate resin, which is a thermoplastic resin, is heated to approximately 300 °C, and by stretching it along a roll, a film is created. Thereafter, a cylinder metallic mold is used, such that the shape of the light reusing sheet 20 is cut out, and the heated film is cooled (the cylindrical metallic mold which is cut out in the shape of a light reusing sheet 20 is set to 80 °C with a water cooling type roll) while applying pressure. In this way, the viscosity of the thermoplastic resin is reduced, and a hardening is achieved in a condition in which the shape of the light reusing sheet 20 is maintained.

According to the light reusing sheet 20 created by this method, the shape of the light reusing sheet 20 is formed so as to comprise a first concaved and convex structure of a lenticular lens form so that the angle of the reflecting surface 100 with a pitch of 80 μm comprises a portion with 30 degrees, as well as a second concaved and convex structure of a triangular prism form such that the angle of the reflecting surface 100 with a pitch of 40 μm comprises a portion with 30 degrees so as to cross orthogonally with the longitudinal direction of the first concaved and convex structure.

In this way, it is possible to create a light reusing sheet 20 at once according to an extrusion system by a roll-to-roll (the sending velocity of the film being equal to 1.5 m/min) configuration using a lens metallic type roll.

When the surface shape of this light reusing sheet 20 was measured with a confocal scanning laser microscope OLS 1100 with 100 points at a 20 μm pitch, the Gaussian curvature Kg became zero at 93 points. At 65 points, the angle of the reflecting surface 100 became 22.5 degrees to 30 degrees.

Further, the reflecting layer 4 was created on its top by applying approximately 20 nm of aluminum via vapor deposition. In addition, when this light reusing sheet 20 created as described above was measured with Easy Contrast (view angle measuring device) manufactured by ELDIM Corporation, a light distribution which is approximately the same as shown in FIG. 8E was obtained.

Here, according to the manufacturing method of the First Working Example, the shape of the light reusing sheet 20 may be easily altered by replacing one of the two cooling rolls to an alternate one having a different lens shape. Meanwhile, the method of the Second Working Example is advantageous because it is more simple since there is less need to set the cooling temperature of the two cooling rolls or to optimize the pressurized condition which were necessary in the First Working Example.

(Third Working Example)

As the third working example, an ultraviolet cure resin was hardened and a structured layer 3 was formed by applying the ultraviolet cure resin (urethane acrylate resin manufactured by Nippon Kayaku Corporation (refraction index =1.51)), having as its chief constituent an urethane acrylate forming a pattern of the light reusing sheet 20, on top of an optical biaxially stretched highly adhesive PET film (thickness of film = 125 μm), and by using a cylinder metallic mold which is cut out in the shape of the reflecting surface 100 of the light reusing sheet 20, and exposing ultraviolet ray from the side of the PET film while transporting the film on which the ultraviolet cure resin is applied. After the hardening, the metallic mold is separated from the PET film. As a result, the shape of the light reusing sheet 20 is formed so as to comprise a first concaved and convex structure of a lenticular lens form so that the angle of the reflecting surface 100 with a pitch of 100 μm comprises a portion with 30 degrees, as well as a second concaved and convex structure of a triangular prism form such that the angle of the reflecting surface 100 with a pitch of 75 μm comprises a portion with 30 degrees so as to cross orthogonally with the longitudinal direction of the first concaved and convex structure.

When the surface shape of this light reusing sheet 20 was measured with a confocal scanning laser microscope OLS 1100 with 100 points at a 25 μm pitch, the Gaussian curvature Kg became zero at all points. At 75 points, the angle of the reflecting surface 100 became 22.5 degrees to 30 degrees.

In addition, when this light reusing sheet 20 created as described above was measured with Easy Contrast (view angle measuring device), a light distribution which is approximately the same as shown in FIG. 8C was obtained.

(Fourth Working Example)

As the fourth working example, the light reusing sheet 20 is obtained by layering on top of a 250 μm PET film being the base material 2, a structured layer 3 obtained by creating a concaved and convex structure of a prism form from the ultraviolet curing acrylic resin such that the angle of the reflecting surface 100 with a pitch of 150 μm equals 30 degrees, and by creating an aluminum layer of 20 nm as the metallic reflecting layer 4 according to the vapor deposition method. Using this light reusing sheet 20, the solar battery module 200 was created. The packed bed 21 was created by having a glass sheet of approximately 2 mm as the front surface board 22, by placing the solar battery cell 30 at a position 1.0 mm from the front surface board 22, and by filling in EVA so that the thickness becomes approximately 1.5 mm. The efficiency of producing electricity was measured by using a multicrystal type as the solar battery cell 30 and by using one such that the peripheral white space of the solar battery cell 30 equals approximately 10 percent with respect to the total area of the solar battery module 200. Table 1 shows the results of the efficiency of producing electricity.

(Fifth Working Example)

As the fifth working example, the configuration of the above fourth working example was altered so that an acrylic resin blended with titanium oxide at a percentage of 30% is used for the structured layer 21, the reflecting layer 4 is not provided, and the light reusing sheet 20 is created by using similarly a PET film of 250 μm as the base material 2. In this way, similar measurements were made. The results of the measurements are shown in the fifth working example section in Table 1.

(First Comparative Example)

As the first comparative example, similar measurement was made with respect to the solar battery module 200 having a conventional configuration, and the efficiency of generating electricity was compared. The measurement results are shown in the first comparative example section in Table 1. According to a conventional configuration, a white PET of 250 μm is placed at the back side instead of the light reusing sheet 20.

From the results shown in Table 1, it is possible to conclude that a solar battery's efficiency of generating electricity is enhanced by using a light reusing sheet 20 according to the present invention.

[Table 1]

| | Irradiated Relative Light Volume to the Light Receiving Surface | Percentage of Enhancement in Generating Electricity [%] |
|---|---|---|
| Comparative Example 1 | 1.00000 | - |
| Fourth Working Example | 1.02482 | 2.5 |
| Fifth Working Example | 1.01742 | 1.7 |

(Sixth Working Example)

As the sixth working example, a 250 μm PET film is used as the base material 2. As the structured layer 3, a substance, comprised by an ultraviolet curable acrylic resin having a concaved and convex form of a prism form such that the apex angle of the reflecting surface 100 with a pitch of 150 μm is 135°, is layered. An aluminum layer of 100 nm is formed by vapor deposition method as the metallic reflecting layer 4. In this way, the light reusing sheet 20 is obtained. Using this light reusing sheet 20, the solar battery module 200 was created. The packed bed 21 was created by having a glass sheet of approximately 3 mm as the front surface board 22, by placing the solar battery cell 30 at a position 0.5 mm from the front surface board 22, and by filling in EVA so that the thickness becomes approximately 0.5 mm. The efficiency of producing electricity was measured by using a multicrystal type silicon solar battery with 150 mm square as the solar battery cell 30, and by placing the above light reusing sheet 20 with a width of approximately 25 mm in the peripheral portion of the solar battery cell 30. Table 2 shows the results of the efficiency of producing electricity.

(Seventh Working Example)

As the seventh working example, a 250 μm PET film is used as the base material 2. As the structured layer 3, a substance, comprised by an ultraviolet curable acrylic resin having a concaved and convex form of a prism form such that the apex angle of the reflecting surface 100 with a pitch of 200 μm is 130°, is layered. An aluminum layer of 100 nm is formed by vapor deposition method as the metallic reflecting layer 4. In this way, the light reusing sheet 20 is obtained. Using this light reusing sheet 20, the solar battery module 200 was created. The packed bed 21 was created by having a glass sheet of approximately 3 mm as the front surface board 22, by placing the solar battery cell 30 at a position 0.5 mm from the front surface board 22, and by filling in EVA so that the thickness becomes approximately 0.5 mm. The efficiency of producing electricity was measured by using a multicrystal type silicon solar battery with 150 mm square as the solar battery cell 30, and by placing the above light reusing sheet 20 with a width of approximately 25 mm in the peripheral portion of the solar battery cell 30. Table 2 shows the results of the efficiency of producing electricity.

(Eighth Working Example)

As the eighth working example, a 250 μm PET film is used as the base material 2. As the structured layer 3, a substance, comprised by an ultraviolet curable acrylic resin having a concaved and convex form of a prism form such that the apex angle of the reflecting surface 100 with a pitch of 100 μm is 125°, is layered. An aluminum layer of 100 nm is formed by vapor deposition method as the metallic reflecting layer 4. In this way, the light reusing sheet 20 is obtained. Using this light reusing sheet 20, the solar battery module 200 was created. The packed bed 21 was created by having a glass sheet of approximately 3 mm as the front surface board 22, by placing the solar battery cell 30 at a position 0.5 mm from the front surface board 22, and by filling in EVA so that the thickness becomes approximately 0.5 mm. The efficiency of producing electricity was measured by using a multicrystal type silicon solar battery with 150 mm square as the solar battery cell 30, and by placing the above light reusing sheet 20 with a width of approximately 25 mm in the peripheral portion of the solar battery cell 30. Table 2 shows the results of the efficiency of producing electricity.

(Ninth Working Example)

As the ninth working example, a 250 $\mu$m PET film is used as the base material 2. As the structured layer 3, a substance, comprised by an ultraviolet curable acrylic resin having a concaved and convex form of a prism form such that the apex angle of the reflecting surface 100 with a pitch of 300 $\mu$m is 120°, is layered. An aluminum layer of 100 nm is formed by vapor deposition method as the metallic reflecting layer 4. In this way, the light reusing sheet 20 is obtained. Using this light reusing sheet 20, the solar battery module 200 was created. The packed bed 21 was created by having a glass sheet of approximately 3 mm as the front surface board 22, by placing the solar battery cell 30 at a position 0.5 mm from the front surface board 22, and by filling in EVA so that the thickness becomes approximately 0.5 mm. The efficiency of producing electricity was measured by using a multicrystal type silicon solar battery with 150 mm square as the solar battery cell 30, and by placing the above light reusing sheet 20 with a width of approximately 25 mm in the peripheral portion of the solar battery cell 30. Table 2 shows the results of the efficiency of producing electricity.

(Tenth Working Example)

As the tenth working example, a 250 $\mu$m PET film is used as the base material 2. As the structured layer 3, a substance, comprised by an ultraviolet curable acrylic resin having a concaved and convex form of a prism form such that the apex angle of the reflecting surface 100 with a pitch of 200 $\mu$m is 115°, is layered. An aluminum layer of 100 nm is formed by vapor deposition method as the metallic reflecting layer 4. In this way, the light reusing sheet 20 is obtained. Using this light reusing sheet 20, the solar battery module 200 was created. The packed bed 21 was created by having a glass sheet of approximately 3 mm as the front surface board 22, by placing the solar battery cell 30 at a position 0.5 mm from the front surface board 22, and by filling in EVA so that the thickness becomes approximately 0.5 mm. The efficiency of producing electricity was measured by using a multicrystal type silicon solar battery with 150 mm square as the solar battery cell 30, and by placing the above light reusing sheet 20 with a width of approximately 25 mm in the peripheral portion of the solar battery cell 30. Table 2 shows the results of the efficiency of producing electricity.

(Second Comparative Example)

As the second comparative example, a 250 $\mu$m PET film is used as the base material 2. As the structured layer 3, a substance, comprised by an ultraviolet curable acrylic resin having a concaved and convex form of a prism form such that the apex angle of the reflecting surface 100 with a pitch of 15 $\mu$m is 140°, is layered. An aluminum layer of 100 nm is formed by vapor deposition method as the metallic reflecting layer 4. In this way, the light reusing sheet 20 is obtained. Using this light reusing sheet 20, the solar battery module 200 was created. The packed bed 21 was created by having a glass sheet of approximately 3 mm as the front surface board 22, by placing the solar battery cell 30 at a position 0.5 mm from the front surface board 22, and by filling in EVA so that the thickness becomes approximately 0.5 mm. The efficiency of producing electricity was measured by using a multicrystal type silicon solar battery with 150 mm square as the solar battery cell 30, and by placing the above light reusing sheet 20 with a width of approximately 25 mm in the peripheral portion of the solar battery cell 30. Table 2 shows the results of the efficiency of producing electricity.

(Third Comparative Example)

As the third comparative example, a 250 $\mu$m PET film is used as the base material 2. As the structured layer 3, a substance, comprised by an ultraviolet curable acrylic resin having a concaved and convex form of a prism form such that the apex angle of the reflecting surface 100 with a pitch of 20 $\mu$m is 105°, is layered. An aluminum layer of 100 nm is formed by vapor deposition method as the metallic reflecting layer 4. In this way, the light reusing sheet 20 is obtained. Using this light reusing sheet 20, the solar battery module 200 was created. The packed bed 21 was created by having a glass sheet of approximately 3 mm as the front surface board 22, by placing the solar battery cell 30 at a position 0.5 mm from the front surface board 22, and by filling in EVA so that the thickness becomes approximately 0.5 mm. The efficiency of producing electricity was measured by using a multicrystal type silicon solar battery with 150 mm square as the solar battery cell 30, and by placing the above light reusing sheet 20 with a width of approximately 25 mm in the peripheral portion of the solar battery cell 30. Table 2 shows the results of the efficiency of producing electricity.

(Table 2)

|  | Relative Efficiency of Producing Electricity |
|---|---|
| Sixth Working Example | 110.9% |
| Seventh Working Example | 110.5% |
| Eighth Working Example | 111.6% |
| Ninth Working Example | 112.7% |
| Tenth Working Example | 115.8% |
| Second Comparative Example | 104.3% |
| Third Comparative Example | 105.1 % |

INDUSTRIAL APPLICABILITY

According to a solar battery module based on the present invention, the efficiency of using light is enhanced by reusing incident light. In this way, it is possible to enhance the efficiency of generating electricity.

DESCRIPTION OF REFERENCE NUMERALS

| | |
|---|---|
| 1 | Distribution of Reflected Light |
| 2 | Base Material |
| 3 | Structured Layer |
| 4 | Reflecting Layer |
| 20 | Light Reusing Sheet |
| 21 | Packed Bed |
| 22 | Front Surface Board |
| 23 | Back Surface Board |
| 30 | Solar Battery Cell |
| 40 | Protecting Layer / Protecting Film |
| 50 | Illuminating Element |
| 100,101,102 | Reflecting Surface |
| 105 | Sheet Surface |
| 110 | Incident Surface |
| 120 | Ridge Line of Reflecting Surface |
| 150 | Ejection Surface |
| 150 | Illuminating Surface |
| 200 | Solar Battery Module |
| 210 | Light Source Module |
| 301,302,303,304,311,312,321,322,331,332,333,390 400 | Angular Range of Reflecting Surface |
| F | Direction of Light Source |
| H0 | Incident Light to Solar Battery Module |
| H1, H11, H12 | Incident Light to Reflecting Surface |
| H2, H21, H22 | Reflecting Light |
| H3 | Incident Light to Light Receiving Surface |
| H10 | Incident Light to Solar Battery Cell |
| J | Light Receiving Surface |
| Kg | Gaussian Curvature |
| K | Curvature |
| K1 | Minimum Curvature |
| K2 | Maximum Curvature |
| L | Light Source |
| M0 | Ejected Light |
| M1 | Reflecting Light |

| M2 | Incident Light |
|---|---|
| M30 | Ejected Light |
| M31 | Reflecting Light |
| MD | Direction of Sheet Width |
| N | Normal Line |
| N0, N1, N2 | Normal Line of Reflecting Surface |
| NB | Sheet Normal Line |
| NG | Normal Line of Front Surface Board |
| P | Planar Surface |
| R | Region Between Adjacent Solar Battery Cells |
| R2 | Region Surrounding Illuminating Element |
| TD | Direction of Sheet Flow |
| $\theta1, \theta2$ | Angle of Reflecting Surface |
| $\theta c$ | Critical Angle |
| $\alpha$ | Peak Angle Formed by Reflecting Surface |

**Claims**

1.  A light reusing sheet for a solar battery module comprising a reflecting layer comprising a reflecting surface which reflects light, wherein
    a Gaussian curvature of the reflecting surface equals zero.

2.  A light reusing sheet for a solar battery module comprising a reflecting layer comprising a reflecting surface which reflects light, wherein
    among the reflecting surface, a percentage of an area of the reflecting surface at which a Gaussian curvature equals zero is greater than or equal to 90 percent of a total area of the reflecting surface.

3.  The light reusing sheet for the solar battery module according to either one of claim 1 or 2, wherein the reflecting surface comprises a concaved and convex form, and the concaved and convex form has a periodicity.

4.  The light reusing sheet for the solar battery module according to claim 3, wherein a pitch of the periodicity of the concaved and convex form is greater than or equal to 25 $\mu$m and is less than or equal to 300 $\mu$m.

5.  The light reusing sheet for the solar battery module according to claim 3, wherein a pitch of the periodicity of the concaved and convex form is greater than or equal to 50 $\mu$m and is less than or equal to 200 $\mu$m.

6.  A solar battery module comprising:

    a transparent front surface board receiving an incidence of a light;
    a packed bed which allows a light, which passed through the front surface board, to pass through;
    a solar battery cell comprising a light receiving surface and is fixed by the packed bed, wherein a light which passed through the packed bed is received by the receiving light surface and is converted into electricity; and
    a light reusing sheet positioned at a back surface side of the light receiving surface of the solar battery cell, the light reusing sheet comprising a reflecting layer comprising a reflecting surface which reflects a light which was not received by the light receiving surface, wherein
    a Gaussian curvature of the reflecting surface equals zero.

7.  A solar battery module comprising:

    a transparent front surface board receiving an incidence of a light;
    a packed bed which allows a light, which passed through the front surface board, to pass through;
    a solar battery cell comprising a light receiving surface and is fixed by the packed bed, wherein a light which passed through the packed bed is received by the receiving light surface and is converted into electricity;
    a light reusing sheet positioned at a back surface side of the light receiving surface of the solar battery cell, the light reusing sheet comprising a reflecting layer comprising a reflecting surface which reflects a light which was not received by the light receiving surface, wherein
    among the reflecting surface, a percentage of an area of the reflecting surface such that a Gaussian curvature equals zero is greater than or equal to 90 percent of a total area of the reflecting surface.

8. The solar battery module according to either one of claim 6 or 7, wherein
a refraction index n of a material, at a front surface board side of the reflecting surface, and an angle θ (deg) between a normal line of the front surface board and a normal line of the reflecting surface satisfy a first equation θ≥ arcsin(1/n)/2, and an apex angle α (deg) of the reflecting surface satisfies a second equation α ≥ (arcsin(1/n)+180)/2.

9. The solar battery module according to either one of claim 6 or 7, wherein
a percentage of an area of the reflecting surface satisfying the following condition is greater than or equal to 50 percent of a total area of the reflecting surface:

a refraction index n of a material, at a front surface board side of the reflecting surface, and an angle θ (deg) between a normal line of the front surface board and a normal line of the reflecting surface satisfy a first equation θ ≥ arcsin(1/n)/2, and
an apex angle α (deg) of the reflecting surface satisfies a second equation α ≥ (arcsin(1/n)+180)/2.

10. The solar battery module according to either one of claim 6, 7, 8, or 9, wherein the reflecting surface comprises a concaved and convex form, and the concaved and convex form has a periodicity.

11. The solar battery module according to claim 10, wherein a pitch of the periodicity of the concaved and convex form is greater than or equal to 25 μm and is less than or equal to 300 μm.

12. The solar battery module according to claim 10, wherein a pitch of the periodicity of the concaved and convex form is greater than or equal to 50 μm and is less than or equal to 200 μm.

# FIG. 1

# FIG. 2

# FIG. 3

# FIG. 4

# FIG. 5

# FIG. 6

FIG. 7

FIG. 8A

FIG. 8B

FIG. 8C

FIG. 8D

FIG. 8E

# FIG. 9

# FIG. 10

# FIG. 11

CHANGE IN REFLECTION RATE ACCORDING TO INCIDENT ANGLE

CRITICAL ANGLE $\theta$c

# FIG. 12

# FIG. 13

# FIG. 14

# FIG. 15

# FIG. 16

# FIG. 17

# FIG. 18

# FIG. 19

# FIG. 20

# FIG. 21

# FIG. 22

# FIG. 23

# FIG. 24

# FIG. 25

# FIG. 26

# FIG. 27

# FIG. 28

FIG. 29

FIG. 30

# FIG. 31

# FIG. 32

# FIG. 33

# FIG. 34

# FIG. 35

**INTERNATIONAL SEARCH REPORT**

| International application No. |
|---|
| PCT/JP2009/005131 |

A. CLASSIFICATION OF SUBJECT MATTER
*H01L31/042*(2006.01)i

According to International Patent Classification (IPC) or to both national classification and IPC

B. FIELDS SEARCHED

Minimum documentation searched (classification system followed by classification symbols)
H01L31/042

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2001-119054 A  (Hitachi, Ltd.), 27 April 2001 (27.04.2001), paragraphs [0023] to [0024]; fig. 1 (Family: none) | 1-12 |
| X | JP 2000-323740 A  (Hitachi, Ltd.), 24 November 2000 (24.11.2000), paragraphs [0007] to [0009], [0016] (Family: none) | 1-12 |
| A | JP 2002-43600 A  (President of Tokyo University of Agriculture and Technology), 08 February 2002 (08.02.2002), fig. 1 (Family: none) | 1-12 |

[X] Further documents are listed in the continuation of Box C.      [ ] See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 04 December, 2009 (04.12.09) | 15 December, 2009 (15.12.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

INTERNATIONAL SEARCH REPORT

International application No.

PCT/JP2009/005131

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2002-513210 A  (ASE Americas, Inc.),<br>08 May 2002 (08.05.2002),<br>entire text; all drawings<br>& US 5994641 A          & WO 1999/056317 A1 | 1-12 |
| A | JP 63-34982 A  (Mitsubishi Electric Corp.),<br>15 February 1988 (15.02.1988),<br>entire text; all drawings<br>(Family: none) | 1-12 |
| A | JP 11-307791 A  (Sanyo Electric Co., Ltd.),<br>05 November 1999 (05.11.1999),<br>entire text; all drawings<br>(Family: none) | 1-12 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008258307 A
- JP 2008295371 A
- JP 2001295437 A
- JP H461285 B
- JP H11274533 B
- JP H11307791 B